# EUROPEAN PATENT APPLICATION

(11) **EP 4 615 208 A1**
(43) Date of publication of application: **10.09.2025**
(21) Application number: 24805754.9
(22) Date of filing: 04.11.2024
(51) Int. Cl.: H10K 59/80, H10K 59/35, H10K 59/40, H10K 59/121, H10K 59/131, H10K 59/38, G09G 3/325

(54) **DISPLAY DEVICE AND ELECTRONIC DEVICE FOR CONTROLLING VIEWING ANGLE**

(30) Priority: 25.01.2024 KR 20240011747; 11.03.2024 KR 20240034173
(71) Applicant: Samsung Electronics Co., Ltd, Suwon-si, Gyeonggi-do 16677 (KR)
(72) Inventor: SHIN, Sungyoung, Suwon-si, Gyeonggi-do 16677 (KR); PARK, Keehyon, Suwon-si, Gyeonggi-do 16677 (KR); YANG, Byungduk, Suwon-si, Gyeonggi-do 16677 (KR); UHM, Minsuk, Suwon-si, Gyeonggi-do 16677 (KR); LEE, Haechang, Suwon-si, Gyeonggi-do 16677 (KR); KIM, Kwangtai, Suwon-si, Gyeonggi-do 16677 (KR); YEOM, Donghyun, Suwon-si, Gyeonggi-do 16677 (KR)
(74) Representative: Gulde & Partner
(86) International application number: PCT/KR2024/017209
(87) International publication number: WO 2025/159284

(57) **Abstract**

A display device includes a pixel layer including a plurality of pixels including a first pixel and a second pixel positioned adjacent to the first pixel, a masking layer including black matrix portions and light transmittance portions disposed such that light from the first pixel is emitted with a first viewing angle limited by a portion of the black matrix portions and light from the second pixel is emitted with a second viewing angle limited by a portion of the black matrix portions, the second viewing angle being narrower than the first viewing angle, a transparent layer disposed between the pixel layer and the masking layer such that the masking layer is spaced apart by a specified distance from the pixel layer for the second viewing angle, and a touch sensitive panel layer disposed between the masking layer and the transparent layer and including an insulation layer and a plurality of touch sensitive electrodes. The insulation layer of the touch sensitive panel layer is omitted beneath the light transmittance portion of the masking layer.

## Description

### [Technical Field]

The disclosure relates to a display device and an electronic device for controlling a viewing angle.

### [Background Art]

Portable electronic devices may communicate visual information to the outside via a display. A display may convey visual information with a combination of light transmitted by pixels. Portable electronic devices are widely used in a variety of environments. For example, a wide viewing angle may be required when several people watching contents together, or a narrow viewing angle may be required when viewing private information that they do not want to be exposed to others. Thus, a viewing angle of light transmitted via a display may be determined depending on an angle of the light transmitted by the pixels.

The above information is presented as a related art only to assist with an understanding of the disclosure. No determination has been made, and no assertion is made, as to whether any of the above might be applicable as a prior art with regard to the disclosure.

### [Detailed Description of the Invention]

### [Technical Solution]

A display device is disclosed. The display device includes a pixel layer. The pixel layer includes a plurality of pixels including a first pixel and a second pixel positioned adjacent to the first pixel. The display device includes a masking layer. The masking layer includes black matrix portions and light transmittance portions disposed such that light from the first pixel is emitted with a first viewing angle limited by a part of the black matrix portions and light from the second pixel is emitted with a second viewing angle limited by a part of the black matrix portions, wherein the second viewing angle is narrower than the first viewing angle. The display device includes a transparent layer. The transparent lay is disposed between the pixel layer and the masking layer such that the masking layer is spaced apart by a designated distance from the pixel layer for the second viewing angle. The display device includes a touch sensitive layer. The touch sensitive layer is disposed between the masking layer and the transparent layer and may include an insulation layer and a plurality of touch sensitive electrodes. The insulation layer of the touch sensitive layer is omitted beneath the light transmittance portions of the masking layer.

A display device is disclosed. The display device may include a pixel layer. The pixel layer may include a plurality of pixels including a first pixel and a second pixel, positioned adjacent to the first pixel. The display device may include a transparent layer disposed above the pixel layer. The display device may include a touch sensitive layer disposed on the transparent layer, including an insulation layer and a plurality of touch sensitive electrodes. The display device may include a masking layer disposed on the touch sensitive layer. The masking layer may include a black matrix portion, and a first light transmittance portion and a second light transmittance portion disposed to emit light from the first pixel with a first viewing angle limited by the black matrix portion and emit light from the second pixel with a second viewing angle limited by the black matrix portion. The second viewing angle may be less than the first viewing angle. The touch sensitive layer may be visually obscured by the black matrix portion.

### [Brief Description of the Drawings]

FIG. 1A and 1B illustrate an example of some pixels of a display device according to an embodiment.
FIG. 2 illustrates a positional relationship between a pixel and a masking layer in a display device according to an embodiment.
FIG. 3 illustrates a change in a characteristic of a touch sensitive electrode according to a change in a distance between a touch sensitive electrode and a pixel electrode of a display device, according to an embodiment.
FIG. 4A illustrates an arrangement of a first pixel and a second pixel of the example display device.
FIG. 4B illustrates an arrangement of a first pixel and a second pixel of an example display device from which a color filter layer is removed.
FIG. 4C illustrates an arrangement of a first pixel and a second pixel of an example display device from which a color filter layer and a black matrix of the color filter layer are removed.
FIG. 5A illustrates an example touch sensitive layer from which a portion of an insulation layer is removed.
FIG. 5B illustrates a relationship between a conductive pattern and a bridge in a touch sensitive layer.
FIGS. 6A, 6B, and 6C illustrate an example display device in which an insulation layer in a touch sensitive layer is formed of the same material as other layers.
FIGS. 7A, 7B, and 7C illustrate an example display device including a refractive index matching layer for matching a refractive index of light transmitted to the outside.
FIGS. 8A, 8B, and 8C illustrate example structures providing micro-pixels for implementing a narrow viewing angle.
FIGS. 9A, 9B, 9C, 9D, and 9E illustrate an arrangement of an optical member for adjusting a refractive index of light emitted from a first pixel and a second pixel.
FIG. 10A illustrates an arrangement of an example touch sensitive layer disposed between a transparent layer and a lower planarization layer.
FIG. 10B illustrates an arrangement of a touch sensitive layer interposed in the transparent layer.
FIGS. 10C and 10D illustrate an arrangement of an example touch sensitive layer including a conductive pattern disposed on a first pixel.
FIG. 11 is a flowchart illustrating an operation of providing a portion of a display area of a display in a private mode.
FIGS. 12A, 12B, and 12C illustrate an example in which a private display is applied to a portion of a display area of a display.
FIG. 13 is a block diagram of an electronic device in a network environment according to an embodiment.
FIG. 14 is a block diagram of a display module according to an embodiment.

### [Mode for Carrying out the Invention]

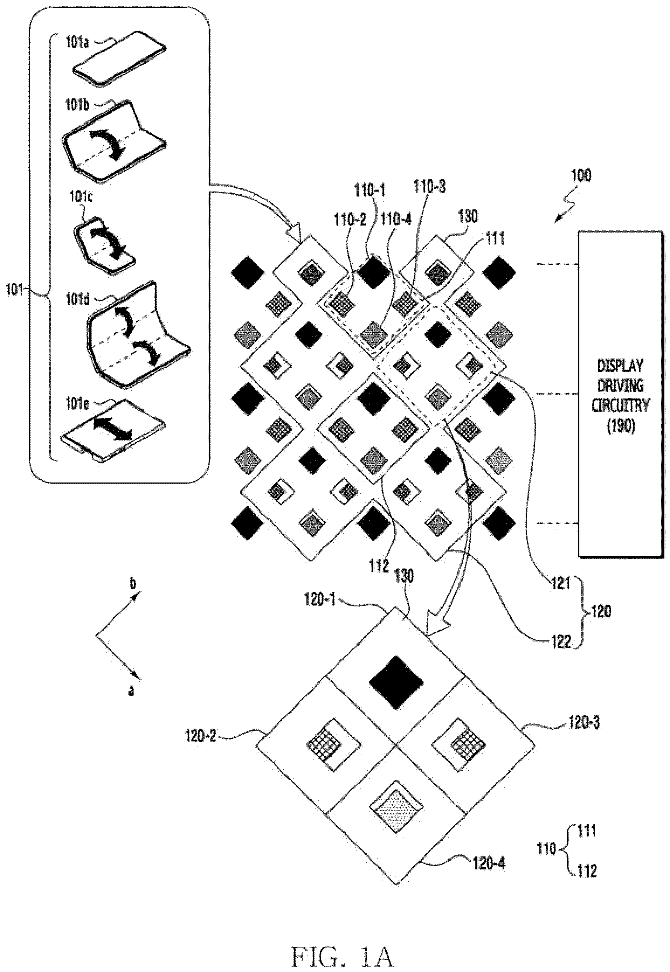

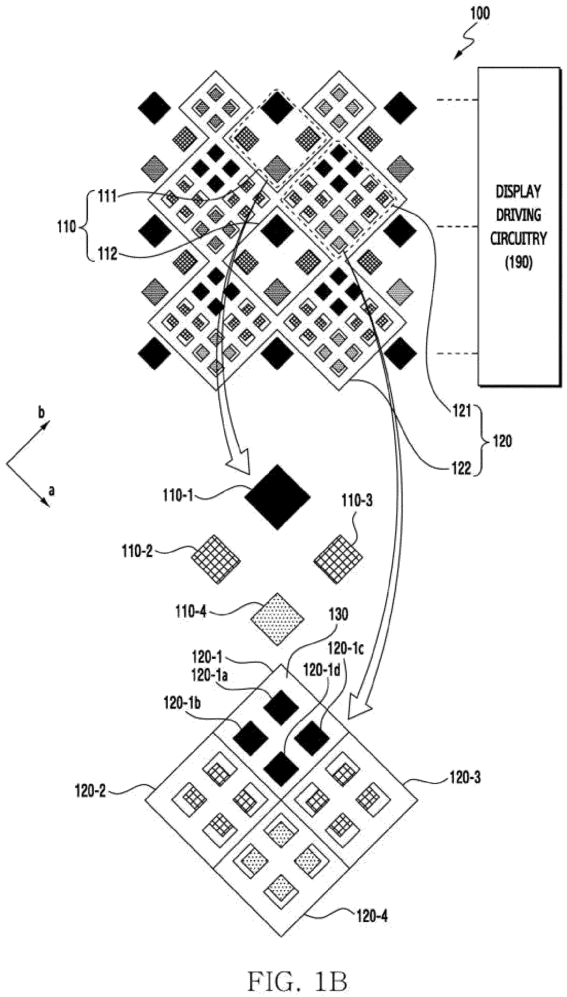

FIGS. 1A and 1B show an example of some pixels of a display device according to an embodiment.

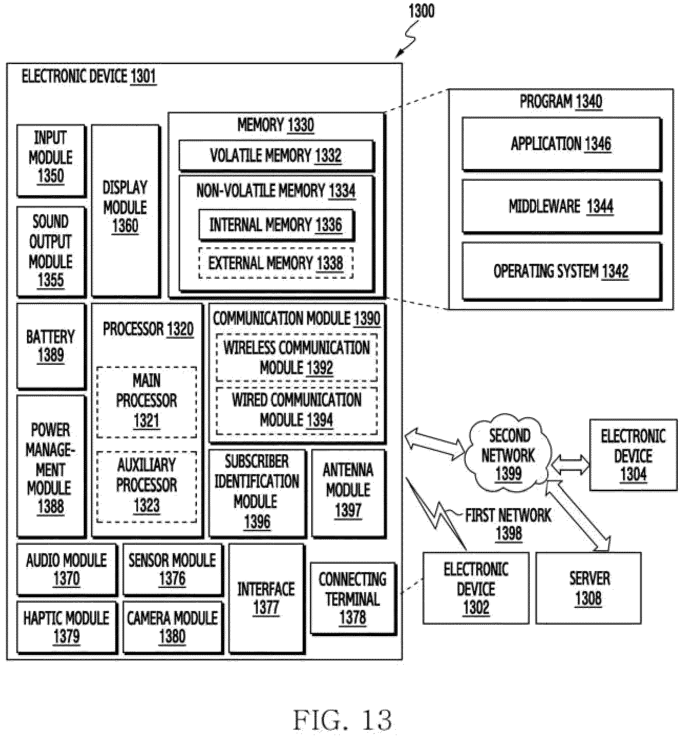

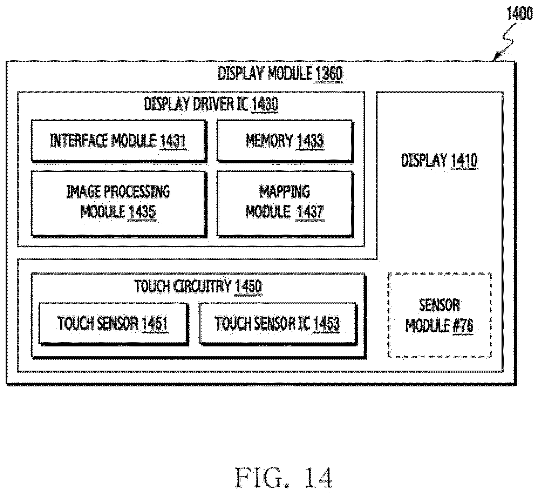

Referring to FIG. 1A, an electronic device 101 (e.g., an electronic device 1301 of FIG. 13) may include a display device 100. The electronic device 101 may be one of various types of electronic devices. For example, the electronic device 101a may include the display device 100 of which shape does not change. Electronic devices 101b, 101c, 101d, and 101e may include a display device 100 that is changed in shape. The electronic devices 101b, 101c, and 101d may be referred to as a foldable electronic device in terms of the display device 100 being folded or unfolded with respect to a folding axis. For the electronic device 101b, the display device 100 may be folded or unfolded with respect to a folding axis parallel to a long edge of a housing of the electronic device 101b. For the electronic device 101c, the display device 100 may be folded or unfolded with respect to a folding axis parallel to a short edge of a housing of the electronic device 101c. The electronic device 101d may be referred to as a multi-foldable electronic device in terms of including plural folding axes. The electronic device 101e may be referred to as a rollable electronic device or a slidable electronic device, in terms of an operation in which a portion of the display device 100 moves into a housing of the electronic device 101e or the portion of the display device 100 moves out of the housing of the electronic device 101e. The display device 100 (e.g., a display module 1360 of FIGS. 13 and 14) may include a display panel (e.g., a display 1410 of FIG. 14) including a first set 110 of first pixels 111 and 112 and a second set 120 of second pixels 121 and 122, and display driving circuitry 190 (e.g., a display driver IC 1430 of FIG. 14). The display device 100 may be referred to as a display module 1360.

Referring to FIGS. 1A and 1B, the display device 100 may have a set of pixels or pixel areas that provide different viewing angles. The pixel areas may represent areas including a pixel and a region of layers corresponding to or overlapping the pixel. For example, the display device 100 may include the first pixels 111 and 112, and the second pixels 121 and 122 in a pixel area having a viewing angle narrow than a viewing angle of the pixel area including the first pixels 111 and 112. Each of the first pixels 111 and 112 and the second pixels 121 and 122 may refer to one pixel unit.

According to an embodiment, the display device 100 may provide different viewing angles according to driving pixels based on the first pixels 111 and 112, the second pixels 121 and 122, or a combination of each of the first pixels 111 and 112 and each of the second pixels 121 and 122, depending on the environment in which a user is located. The first pixels 111 and 112 may be configured to provide a first viewing angle of light emitted from the first pixels 111 and 112, based on a relationship (arrangement or structure) with the components inside the display device 100. The second pixels 121 and 122 may be configured to provide a second viewing angle of light emitted from the second pixels 121 and 122, based on a relationship with the components inside the display device 100. The second viewing angle may be less than the first viewing angle.

According to an embodiment, the display device 100 may operate in a first mode for providing a wide viewing angle to a user. For example, the display driving circuitry 190 may drive both the first set 110 including the first pixels 111 and 112 and the second set 120 including the second pixels 121 and 122 to provide the user with a wide viewing angle.

According to an embodiment, the display device 100 may operate in a second mode for providing the user with a viewing angle less than that of the first mode. The display driving circuitry 190 may drive the second set 120 including the second pixels 121 and 122 to provide a relatively narrow viewing angle to the user. According to an embodiment, the display driving circuitry 190 may drive all the second pixels 121 and 122 of the second set 120 and a portion of the first pixels 111 and 112 in the first set 110, so as to provide a narrower viewing angle than when driving only the second set 120 and blur its screen when the display is not viewed from the front (e.g., when viewed from a side), thereby lowering its contrast ratio while providing the user with a narrow viewing angle.

According to an embodiment, the first pixels 111 and 112 may be alternately disposed with the second pixels 121 and 122. The first pixels 111 and 112 may be arranged in a first direction (a), and the first pixels 111 and 112 may be spaced apart from each other. The first pixels 111 and 112 may be arranged in a second direction (b), and the first pixels 111 and 112 may be spaced apart from each other. The second pixels 121 and 122 may be disposed between the first pixels 111 and 112. The second pixels 121 and 122 may be arranged in the first direction (a), and the second pixels 121 and 122 may be spaced apart from each other. The second pixels 121 and 122 may be arranged in the second direction (b), and the second pixels 121 and 122 may be spaced apart from each other. It has been described that the first pixels 111 and 112 and the second pixels 121 and 122 are alternately arranged with each other, but the disclosure is not limited thereto. As another example, the first pixels 111 and 112 and the second pixels 121 and 122 may be arranged in the first direction (a), the columns formed by the first pixels 111 and 112 may be spaced apart in the second direction (b), and the columns formed by the second pixels 121 and 122 may be arranged between the columns formed by the first pixels 111 and 112, respectively.

One pixel making up the first set 110 of the first pixels 111 and 112 may include a plurality of subpixels 110-1, 110-2, 110-3, and 110-4. Each of the plurality of sub-pixels 110-1, 110-2, 110-3, and 110-4 may provide a specified color. For example, the first sub-pixel 110-1 of the first pixel 111 may provide red light, the second sub-pixel 110-2 and the third sub-pixel 110-3 of the first pixel 111 may provide green light, and the fourth sub-pixel 110-4 of the first pixel 111 may provide blue light. One vertex of the first sub-pixel 110-1 and one vertex of the fourth sub-pixel 110-4 may face each other, and the second sub-pixel 110-2 or the third sub-pixel 110-3 may be disposed in each of the spaces between the first sub-pixel 110-1 and the fourth sub-pixel 110-4. For example, the second sub-pixel 110-2 may be disposed between one edge of the first sub-pixel 110-1 and one edge of the fourth sub-pixel 110-4 perpendicular to the first sub-pixel 110-1. The plurality of sub-pixels 110-1, 110-2, 110-3, and 110-4 may be distinguished by a pixel definition member (or a pixel define layer (PDL)). The plurality of first pixels 111 and 112 may have substantially the same structure of sub-pixels arrangement as the above-described structure.

According to an embodiment, one pixel making up the second set 120 of the second pixels 121 and 122 may include a plurality of subpixels 120-1, 120-2, 120-3, and 120-4. Each of the plurality of sub-pixels 120-1, 120-2, 120-3, and 120-4 may provide a specified color. For example, the first sub-pixel 120-1 of the second pixel 121 may provide red light, the second sub-pixel 120-2 and the third sub-pixel 120-3 of the second pixel 121 may provide green light, and the fourth sub-pixel 120-4 of the second pixel 121 may provide blue light. The first sub-pixel 120-1, the second sub-pixel 120-2, the fourth sub-pixel 120-4, and the third sub-pixel 120-3 of the second pixel 112 may be sequentially arranged counterclockwise. The plurality of sub-pixels 120-1, 120-2, 120-3, and 120-4 of the second pixel 121 may be distinguished by a pixel definition member or a masking layer 130 disposed inside the display device 100. The plurality of sub-pixels 120-1, 120-2, 120-3, and 120-4 have been described as one pixel providing red light, two pixels providing green light, and one pixel providing blue light, but the disclosure is not limited thereto. For example, sub-pixels making up one pixel may include three sub-pixels providing red, green, and blue, respectively. Sub-pixels making up one pixel may include four sub-pixels providing red, green, blue, and white, respectively. The color and number of sub-pixels may be configured in various manners.

Referring to FIG. 1A, the masking layer 130 includes an opening for distinguishing the subpixels 120-1, 120-2, 120-3, and 120-4, but the disclosure is not limited thereto.

Referring to FIG. 1B, the masking layer 130 may further include openings for dividing each of the plurality of sub-pixels 120-1, 120-2, 120-3, and 120-4 of the second pixel 121. For example, the first sub-pixel 120-1 of the second pixel 121 may be divided into a plurality (e.g., two or four) of micro-pixels 120-1a, 120-1b, 120-1c, and 120-1d by the masking layer 130. The masking layer 130 may divide the first sub-pixel 120-1 of the second pixel 121 into four micro-pixels 120-1a, 120-1b, 120-1c, and 120-1d through four openings, respectively. A viewing angle provided by the first sub-pixel 120-1 may be determined by a distance between the openings making up the masking layer 130 or a size of the openings. The display device 100 according to the above-described embodiment may have the first set 110 of the plurality of first pixels 111 and 112 providing a wide viewing angle and the second set 120 of second pixels 121 and 122 providing a viewing angle less than the viewing angle provided through the first pixels 111 and 112, thereby driving all of the pixels or driving some designated pixels based on an input or according to a change in environment. Such a change in environment may refer to whether or not a user is within a range of a designated place. For example, in pixel driving according to the change in environment, when the electronic device (e.g., the electronic device 1301 of FIG. 13) including the display device 100 is located at a first place (e.g., home or lodging) specified by a user, or within a certain range including the first place, the processor (e.g., the processor 1320 of FIG. 13 or the display driver IC 1430 of FIG. 14) may provide a first mode driving all pixels both in the first set 110 and the second set 120. When the electronic device 101 is out of the first place or the range including the first place, the processor 1320 may provide a second mode driving all the pixels in the second set 120, or driving all the pixels in the second set 120 and some pixels in the first set 110, thus providing a viewing angle less than a viewing angle provided in the first mode. Therefore, according to the change in environment, the electronic device 101 may transmit visual information having a different viewing angle and a different contrast ratio to the user. For example, the viewing angle may be adjusted according to the user's needs by changing to the first mode or the second mode via the user's touch or key button input. The display device 100 may provide visual information of a wide viewing angle and a high contrast ratio in its first mode, and provide visual information of a narrow viewing angle and a low contrast ratio in its second mode, thereby restricting another user from accessing the visual information.

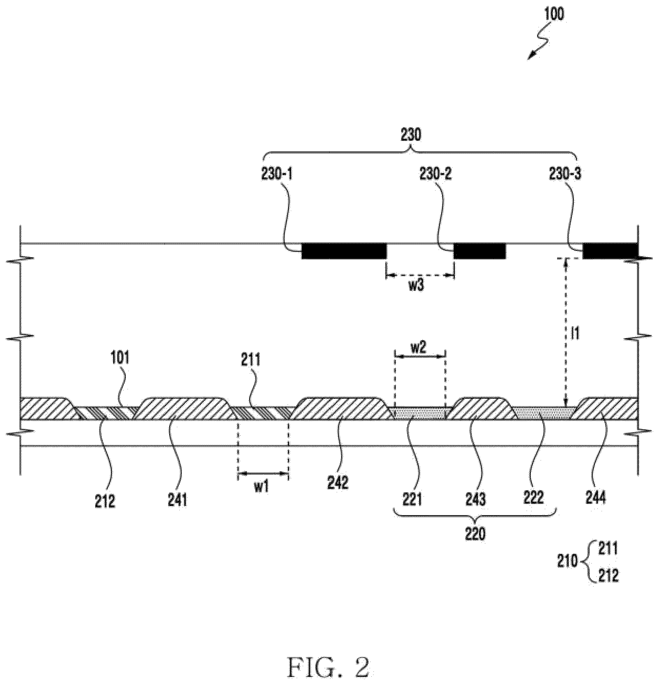

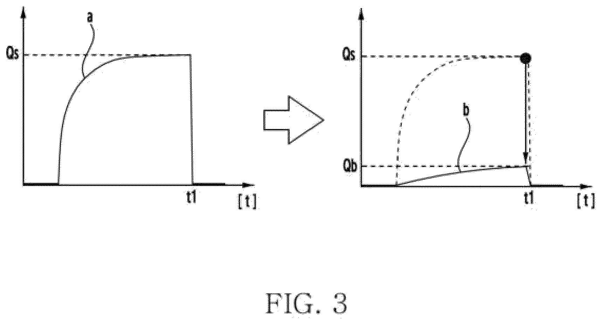

FIG. 2 illustrates a positional relationship between a pixel and a masking layer in a display device according to an embodiment, and FIG. 3 illustrates a change in characteristic of a touch sensitive electrode depending upon a change in distance between a touch sensitive electrode and a pixel electrode in a display device, according to an embodiment.

FIG. 2 illustrates a cross-sectional view of the display device of FIG. 1A. Referring to FIG. 2, the display device 100 may include a first pixel 210 (e.g., the first pixels 111 and 112 of FIG. 1A) and a second pixel 220 (e.g., the second pixels 121 and 122 of FIG. 1A). The display device 100 may include sub-pixels 211 and 212 (e.g., the sub-pixels 110-1, 110-2, 110-3, and 110-4 of the first pixel of FIG. 1A) of the first pixel 210 and the sub-pixels 221 and 222 (e.g., the sub-pixels 120-1, 120-2, 120-3, and 120-4 of the second pixel of FIG. 1A) of the second pixel 220. Each of the subpixels 211, 212, 221, and 222 may include an organic light emitting diode (OLED) having an organic light emitting material capable of emitting light in a designated color. The sub-pixel 221 of the second pixel 220 may be disposed to be spaced apart from the sub-pixel 211 of the first pixel 210.

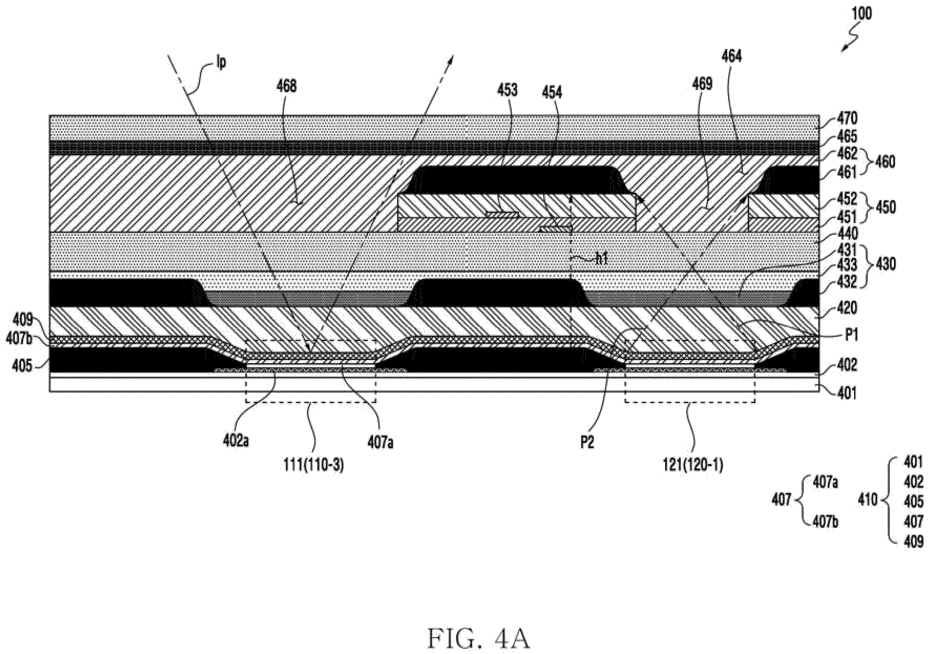

According to an embodiment, the pixel definition members 241, 242, 243, and 244 (or pixel define layer, PDL) may distinguish the first pixel 210 and the second pixel 220, and may distinguish the sub-pixels 211, 212, 221, and 222 of each of the first pixel 210 and the second pixel 220. The pixel definition members 241, 242, 243, and 244 may serve to distinguish such that an organic material of each sub-pixel of an organic light emitting layer 101 (e.g., an organic light emitting layer 407 of FIG. 4A) does not interfere with other sub-pixels. The organic light emitting layer 101 may refer to a light source that emits light by itself using an organic material. In the organic light emitting layer 101, electrons and holes may meet in a layer of the organic material to generate light. The organic light emitting layer 101 may be formed by means of deposition. The pixels 210 and 220 or the sub-pixels 211, 212, 221, and 222 may be formed being disposed in cells partitioned by the pixel definition members 241, 242, 243, and 244. According to an embodiment, the pixel definition members 241, 242, 243, and 244 may be arranged between main pixels, such as the first pixel 210 and the second pixel 220 of the organic light emitting layer 101. The pixel definition members 241, 242, 243, and 244 may be disposed between the sub-pixels 211, 212, 221, and 222 of the first pixel 211 and 212 and the second pixel 221 and 222, respectively.

According to an embodiment, when the subpixels 221 and 222 (e.g., the subpixels 120-1, 120-2, 120-3, and 120-4 of FIG. 1A) of the second pixel 220 are split, the pixel definition members 241, 242, 243, and 244 may further distinguish micro-pixels (e.g., the micro-pixels 120-1a, 120-1b, 120-1c, and 120-1d of FIG. 1B) included in the first subpixels 221 and 222 of the second pixel 220. The pixel definition members 241, 242, 243, and 244 may be disposed between the micro-pixels to split the second pixel 220 in a pixel area providing a narrow viewing angle into micro-pixels. For example, unlike the illustrated, the sub-pixels 221 and 222 of the second pixel 220 of the display device 100 may include the micro-pixels (e.g., the micro-pixels 120-1a, 120-1b, 120-1c, and 120-1d of FIG. 1B). Each of the micro-pixels may be disposed in a cell partitioned by an additional pixel definition member other than the pixel definition members 241, 242, 243, and 244. According to an embodiment, a width **w1** of the sub-pixels 211 and 212 of the first pixel 210 in the pixel area providing the first viewing angle may be greater than a width **w2** of the sub-pixels 221 and 222 of the second pixel 220 in the pixel area providing the second viewing angle less than the first viewing angle. However, the disclosure is not limited thereto. The first viewing angle and the second viewing angle may be configured to be adjusted by a black matrix (BM) 230-1, 230-2, and 230-3 of the masking layer 230, and the width **w1** may be formed to be equal to or less than the width **w2.**

According to an embodiment, the viewing angle provided by the sub-pixels 221 and 222 of the second pixel 220 may be determined by a distance from the pixels 210 and 220 to the masking layer 230 spaced apart therefrom. When the distance between the masking layer 230 and the second pixel 220 is short, the viewing angle gets wider, and thus a distance is required to compensate for it. In order to compensate for the viewing angle, a distance **11** from the organic light emitting layer 101 including the pixels 210 and 220 of the display device 100 to a surface formed by the masking layer 230 may be set based on the width **w2** of the subpixels 221 and 222.

According to an embodiment, when a width **w3** between the black matrices 230-1, 230-2, and 230-3 of the masking layer 230 is the same as the widths **w2** of the sub-pixels 221 and 222 of the second pixel 220, the distance **11** between the masking layer 230 and the pixel may be greater than the width **w2** of the micro-pixel in order to reduce the viewing angle.

According to an embodiment, the viewing angle of the light emitted from the second pixel 220 may be determined by the width **w3** between the masking layers 230-1 and 230-2 disposed on the sub-pixel 221 of the second pixel 220 of the display device 100 and the distance **11** between the masking layers 230 and the pixel. The widths **w2** of the sub-pixels 221 and 222 of the second pixel 220 may be equal to or less than the width **w3** between the black matrices 230-1, 230-2, and 230-3 of the masking layer 230. In order to reduce the viewing angle of the light emitted from the second pixel 220, the viewing angle may be reduced by increasing the distance **11** between the masking layer 230 and the pixel. For example, a portion of the black matrix 230-1, 230-2, and 230-3 of the masking layer 230 may overlap the subpixels 221 and 222 of the second pixel 220, when the masking layer 230 is viewed from above. For example, as the width **w3** between the black matrices 230-1, 230-2, and 230-3 of the masking layer 230 disposed on the sub-pixels 221 and 222 of the second pixel 220 becomes narrower, the viewing angle may become narrower. For example, as the width **w3** of the masking layers 230-1 and 230-2 becomes less than the width **w2** of the sub-pixels 221 and 222 of the second pixel 220, the display device 100 may have a narrower viewing angle. Referring to FIG. 3, a graph (a) shows a reference charge amount **Qs** and a saturation time **t1,** and a graph (b) shows an amount of electric charge and a charging time when a distance between a touch sensitive electrode (e.g., a touch sensitive electrode 453 of FIG. 4A) and an electrode of a display panel (e.g., a first electrode layer 402 or a second electrode layer 409 of FIG. 4A) becomes close. The reference electric charge amount **Qs** may vary depending on the distance between the touch sensitive electrode and the electrode of the display panel. For example, when the capacitance increases as two conductors are located close to each other, a value of the reference charge amount to be fully charged may increase, while when the capacitance decreases as the two conductors are far from each other, the value of the reference charge amount to be fully charged may decrease. The time required for a reaction rate of the touch sensitive electrode may have a designated value.

Referring to the graph (a), an external object may be placed onto the touch electrode (or a conductive pattern) or contacted by the external object on the display device 100, and thus a time **t1** may be required to saturate up to a reference charge amount **Qs.** Referring to graph (b), when the distance between the conductive pattern of the touch sensitive electrode and the electrode of the display panel becomes closer, the value of the capacitance may increase. As the value of the capacitance increases, the value of the reference charge amount **Qs** saturated may increase. Due to the increase in the amount of saturated charge, the charging time may increase, and a delay in the reaction time of the touch sensitive electrode may then occur. As the charging time increases, the time at which a sufficient amount of electric charge is obtained may be later than the reference time **t1.** For example, due to the increased capacitance, the amount of charge **Qb** at the reference time **t1** is less than the reference charge amount **Qs,** which may cause a delay, and the response speed of the touch sensitive electrode may be reduced.

According to the description of the graph described above, in order to reduce the delay of the response speed of the touch sensitive electrode, the distance between the touch sensitive electrode and the display panel may be a specified distance or more.

According to an embodiment, in order for the display device 100 to provide a narrow viewing angle, the display device 100 may provide a structure for securing a distance between a pixel (e.g., the first pixel 111 and the second pixel 121 of FIG. 4A) and a masking layer (e.g., the masking layer 460 of FIG. 4A), and a structure for securing a distance between a conductive pattern and an electrode of the display panel. Hereinafter, a structure for securing the distance between the pixel and the masking layer and a structure for securing the distance between the conductive pattern and the electrode of the display panel will be described in detail.

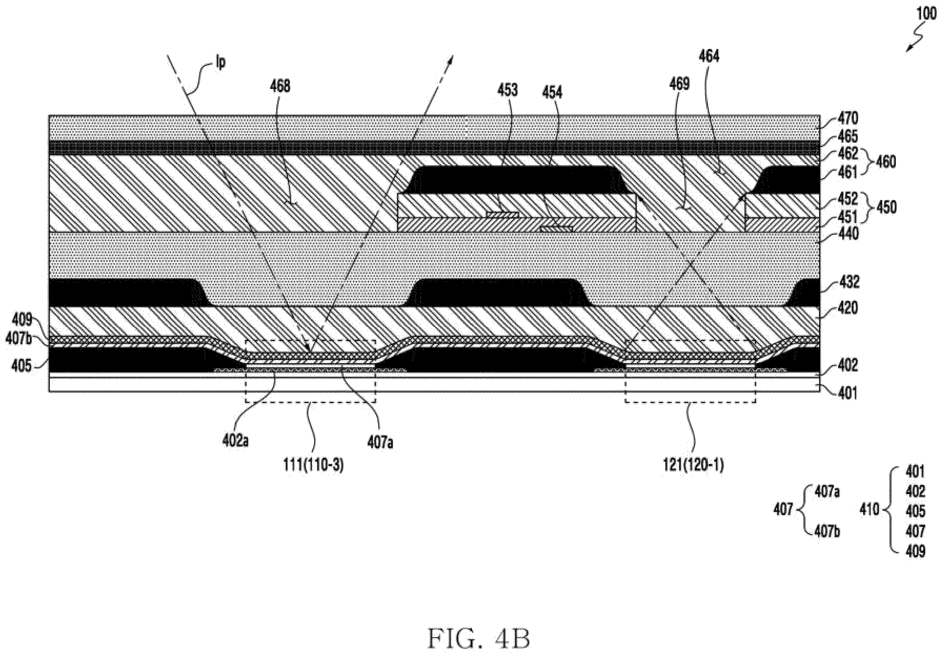

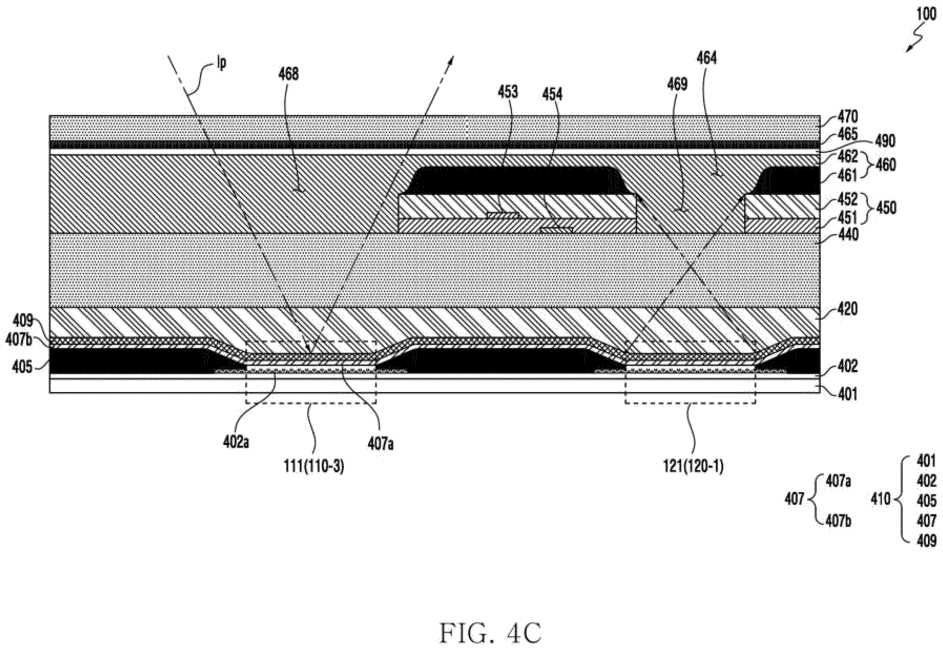

FIG. 4A illustrates an arrangement of a first pixel and a second pixel of an example display device, FIG. 4B illustrates an arrangement of a first pixel and a second pixel of an example display device from which a color filter layer is removed, and FIG. 4C illustrates an arrangement of a first pixel and a second pixel of an example display device from which a color filter layer and a black matrix of the color filter layer are removed.

Referring to FIGS. 4A, 4B, and 4C, a panel (e.g., a display panel) of the display device 100 may include a pixel layer 410, an encapsulation layer 420, a color filter layer 430, a transparent layer 440, a touch sensitive layer 450, a masking layer 460, and a cover layer 470.

According to an embodiment, the pixel layer 410 may include a semiconductor layer 401, a first electrode layer 402, a pixel definition member (PDL) 405, an organic light emitting layer 407, and a second electrode layer 409. The semiconductor layer 401 may include a thin film transistor (TFT). The semiconductor layer 401 may be provided based on low temperature polycrystalline silicon (LTPS) or low temperature polycrystalline oxide (LTPO). The semiconductor layer 401 may be disposed on a substrate. The substrate may include a bendable material such as e.g., polyimide (PI). Although not limited thereto, the semiconductor layer 401 may include a material having rigidity. The semiconductor layer 401 may be disposed underneath the first electrode layer 402 including an anode electrode. The first electrode layer 402 may include a conductive pattern 402a formed to be connected to the semiconductor layer 401. The conductive pattern 402a may be formed in a portion corresponding to the subpixels 111 and 121. For example, the conductive pattern 402a may be disposed below each of the subpixels 111 and 121. The conductive pattern 402a may operate as an anode electrode. The switch in the semiconductor layer 401 may be electrically connected to the anode electrode in the first electrode layer 402. The organic light emitting layer 407 may be disposed on the first electrode layer 402. For example, the organic light emitting layer 407 may be deposited to cover the anode electrode printed on the first electrode layer 402. The organic light emitting layer 407 may be disposed between the second electrode layer 409 including a cathode electrode and the first electrode layer 402 including an anode electrode. The anode electrode in the first electrode layer 402 may form an electric field in the organic light emitting layer 407 together with the cathode electrode in the second electrode layer 409. The anode electrode and the cathode electrode may form an electric field by a thin film transistor in the semiconductor layer 401. By the electric field formed between those electrodes, the organic material in the organic light emitting layer 407 may emit light to the outside. The organic light emitting layer 407 may include an organic material 407a configured to emit red, green, or blue light. The pixel definition member 405 may be formed to surround the light emitting area of the pixel. The organic material 407a of the organic light emitting layer 407 may be patterned to be located in a space between the pixel definition members 405. The organic material 407a of the organic light emitting layer 407 may be deposited in a space between the pixel definition members 405. The organic material 407a capable of emitting light of a certain color may be disposed in an area partitioned by the pixel definition member 405. The organic light emitting layer 407 may further include a layer 407b to provide a movement channel of electrons and holes. As the electrons and the holes moved through the layer 407b meet in the organic material 407a, light may be emitted. Areas corresponding to the area distinguished by the pixel definition member 405 may be referred to as pixels 111 and 121 (or sub-pixels 110-3 and 120-1). The anode electrode of the first electrode layer 402, the organic material 407a (the light emitting organic material) of the organic light emitting layer 407, and the cathode electrode of the second electrode layer 409 may be disposed in the area distinguished by the pixel definition member 405.

According to an embodiment, an encapsulation layer 420 may be formed to cover the second electrode layer 409. The encapsulation layer 420 may be disposed between the color filter layer 430 and the second electrode layer 409. The encapsulation layer 420 may be disposed on the second electrode layer 409 to prevent inflow of external moisture and oxygen into the pixel layer 410 in the panel of the display device 100. The encapsulation layer 420 may include an inorganic layer and/or an organic layer to prevent inflow of moisture and oxygen from the outside. The inorganic layer and/or the organic layer may be alternately arranged, and the encapsulation layer 420 may include two or more inorganic layers to prevent inflow of moisture from the outside. For example, the encapsulation layer 420 may be formed of three layers by sequentially stacking an inorganic layer, an organic layer, and an inorganic layer, or may be formed of five layers by sequentially stacking an inorganic layer, an organic layer, an inorganic layer, an organic layer, and an inorganic layer. The encapsulation layer 420 may be formed to be thin and formed into three layers, or may be formed to be thick and formed into five or more layers, as circumstances demand.

According to an embodiment, the color filter layer 430 may be disposed on the encapsulation layer 420. The color filter layer 430 may have color filters corresponding to a color of light emitted from each of pixels making up the pixel layer 410 and then transmitted through a color filter 431 of the color filter layer 430. For example, when the color of light emitted from pixels in the second set (e.g., the second set 120 of FIGS. 1A and 1B) is red, the color filter 431 may be a filter capable of transmitting red light. The color filter layer 430 may more clearly provide light of a color emitted from each pixel, by emitting the light emitted from the pixel layer 410 to the outside, only each color specified in the filters included in the color filter layer 430. According to an embodiment, the color filter layer 430 may be replaced with a polarized layer.

According to an embodiment, the color filter layer 430 may include a plurality of filters including the color filter 431. A black matrix (BM) 432 may be disposed between the plurality of filters. The black matrix 432 may be disposed to at least partially overlap the pixel definition member 405, when viewing the cover layer 470. The black matrix 432 may be formed to have an opening in an area where the color filter 431 is located. According to an embodiment, the color filter layer 430 may include the black matrix 432, distinguished from the black matrix 461 of the masking layer 460, including an opening corresponding to each of the second pixels 121 and 122 in the second set 120 or the sub-pixels 120-1 (e.g., the sub-pixels 221 and 222 of FIG. 2) of the second pixels 121 and 122. The color filter layer 430 may include a lower planarization layer 433 to cover the black matrix 432 and the color filter 431. The lower planarization layer 433 may be formed of a transparent material. A surface in contact with the black matrix 432 and the color filter 431 amongst the surfaces of the lower planarization layer 433 may be formed of a surface with a bending (or unevenness) corresponding to the black matrix 432 and the color filter 431, and a surface in contact with the transparent layer 440 of the surfaces of the lower planarization layer 433 may be flat.

According to an embodiment, when the panel of the display device 100 has the color filter layer 430, the panel of the display device 100 may include no polarizing plate. When no polarizing plate is included, light incident from the outside and then reflected to the outside by the electrode of the pixel layer 410 may increase. The panel of the display device 100 may include a thin encapsulation layer 420 to reduce reflection of light by its electrode. For example, when the encapsulation layer 420 is thick, the path **lp** of the light reflected through the encapsulation layer 420 becomes longer, and thus the light reflected to the outside may leak out. The panel of the display device 100 may reduce the thickness of the encapsulation layer 420 to shorten the path **lp** of light in the encapsulation layer 420, and thus minimize the amount of reflection of light leaking through the black matrix 432.

According to an embodiment, the transparent layer 440 may be disposed on the color filter layer 430. For example, the transparent layer 440 may be disposed on the lower planarization layer 433. The transparent layer 440 may be formed of a plurality of layers. The transparent layer 440 may include the lower planarization layer 433. The transparent layer 440 may be formed of the same material as that of the lower planarization layer 443. The transparent layer 440 may have substantially the same refractive index as that of the lower planarization layer 443. The transparent layer 440 may be formed to secure a distance **h1** between the black matrix 461 adjacent to the cover layer 470 and the pixel layer 410 (e.g., the first electrode layer 402) in order to secure a narrow viewing angle of the second pixel 121 of the second set 120. The transparent layer 440 may be referred to as a viewing angle compensation layer or a compensation layer in terms of adjusting or compensating a viewing angle of a pixel. The transparent layer 440 may include an organic layer of a material and may include a monomer. The transparent layer 440 may include several stacked layers.

According to an embodiment, the touch sensitive layer 450 may be disposed on the transparent layer 440. The touch sensitive layer 450 may include an insulation layer 451 on which a touch sensitive electrode 453 and a bridge 454 are formed, and a protective layer 452 protecting the touch sensitive electrode 453 and the bridge 454. The touch sensitive electrode 453 and the bridge 454 may be formed on the transparent layer 440 and may be integrally formed with the display panel. The touch sensitive electrode 453 may be disposed on the insulation layer 451. The touch sensitive electrode 453 may be surrounded by the insulation layer 451 and the protective layer 452. The bridge 454 may be disposed on the transparent layer 440 and may be surrounded by the insulation layer 451. To compensate for the performance degradation of the touch sensitive layer 450 due to the thin encapsulation layer 420, another layer may be interposed between the touch sensitive layer 450 and the encapsulation layer 420. For example, the touch sensitive layer 450 may be disposed closer to the cover layer 470. By securing the distance between the touch sensitive layer 450 and the pixel layer 410 through the other layer and reducing the capacitance, the performance of the touch sensitive layer 450 may be secured. For example, when the touch sensitive layer 450 is formed on the encapsulation layer 420, the distance between the touch sensitive layer 450 and the pixel layer 410 is close so that the capacitance increases and thus the amount of charge required for charging increases, thereby the response speed of the touch panel may be delayed. When the touch sensitive layer 450 is disposed on the transparent layer 440, a sufficient distance between the touch sensitive layer 450 and the pixel layer 410 can be achieved, and thus the response speed of the touch panel can be improved as the capacitance decreases.

According to an embodiment, the touch sensitive layer 450 may include a bridge 454 interposed in the insulation layer 451 and the touch sensitive electrode 453 printed on the insulation layer 451. According to an embodiment, the bridge 454 may be printed on the transparent layer 440, and the touch sensitive electrode 453 may be printed on the insulation layer 451 surrounding the bridge 454. According to an embodiment, the touch sensitive electrode 453 and the bridge 454 may be printed on the same layer. For example, the touch sensitive electrode 453 and the bridge 454 may be printed on the transparent layer 440. The touch sensitive electrode 453 may be formed of a plurality of patterns, and the plurality of patterns may be connected by a conductive wire. The conductive wire may be replaced with the bridge 454 connecting patterns of the same polarity. The capacitance of the touch sensitive layer 450 may be changed by an external object (a part of a user's body) contacting or approaching the cover layer 470. Through the capacitance change, the display device 100 or the electronic device (e.g., an electronic device 1301 of FIG. 13) including the panel of the display device 100 may detect an approach or contact of an external object, using the touch sensitive layer 450, and may receive an input based on coordinates of the detected point.

According to an embodiment, the insulation layer 451 may at least partially surround the touch sensitive electrode 453 and the bridge 454. The insulation layer 451 may prevent the touch sensitive electrode 453 and the bridge 454 from being electrically connected to another conductive pattern (e.g., another touch sensitive electrode). For example, when the touch sensitive electrode 453 operates as one touch sensitive electrode and the other conductive pattern operates as another electrode perpendicular to the one touch sensitive electrode, the two electrodes may be spaced apart from each other. The insulation layer 451 may include a single layer or multiple layers formed of a silicon composite. The insulation layer 451 may be a single layer of silicon nitride (SiNx) or silicon oxide (SiOx) or a multi-layered layer thereof.

According to an embodiment, the protective layer 452 may be formed to cover the touch sensitive electrode 453 in order to protect the touch sensitive electrode 453 of the touch sensitive layer 450. The protective layer 452 may be referred to as a passivation (PVX) layer in terms of covering and protecting the touch sensitive electrode 453. The protective layer 452 may be configured to prevent damage to the bridge 453.

According to an embodiment, the masking layer 460 may be disposed between the touch sensitive layer 450 and the cover layer 470. The masking layer 460 may include the black matrix 461 to adjust a viewing angle and reduce the visual visibility of internal wirings of the electronic device (e.g., the electronic device 1301 of FIG. 13) from the outside. The masking layer 460 may be referred to as a light blocking layer, a black ink layer, or a black matrix layer, in terms of suppressing light transmission to prevent an interior of the electronic device from being visible from the outside. When the organic light emitting layer 407 of the display is not driven, the black matrix 461 may include a material formed in black color to provide the display area of the display in black, and may include an opening corresponding to a pixel. The black matrix 461 may be referred to as a black ink or a light blocking material, in that it is formed of an achromatic ink to block external light or reduce the visibility of the interior of the electronic device to the outside. The masking layer 460 may include an upper planarization layer 462 and the black matrix 461. For example, the masking layer 460 may include a layer (e.g., the upper planarization layer 462) capable of planarizing a surface of the display panel for bonding to the cover layer 470. The masking layer 460 may be formed of a monomer multi-layer. The masking layer 460 may be attached to the cover layer 470. For example, an adhesive layer 465 may be disposed between the masking layer 460 and the cover layer 470. The masking layer 460 may include an opening 464 penetrating the black matrix 461. The opening 464 may make up at least a portion of light transmittance portions 468 and 469 through which light emitted from the pixel transmits. An interval between the black matrices 461 may determine a viewing angle of light emitted from the second pixel 121. For example, the viewing angle may be formed by a path P1 through which light emitted from the right side of the set 120 of the second pixel 121 reaches the left side of the opening 464 formed in the black matrix 461 and a path P2 through which light emitted from the left side of the second pixel 121 reaches the right side of the opening formed in the black matrix 461. The masking layer 460 may be attached under the cover layer 470. For example, the adhesive layer 465 may be disposed between the masking layer 460 and the cover layer 470. The upper planarization layer 462 of the masking layer 460 may be omitted in case where the black matrix 461 can be planarized by thickening the adhesive material of the adhesive layer 465.

The masking layer 460 may include a first light transmittance portion 468, a second light transmittance portion 469, and a black matrix 461. The black matrix 461 may not be disposed in a portion of the masking layer 460 corresponding to a first pixel 111. For example, the masking layer 460 may include the first light transmittance portion 468 surrounded by the black matrix 461 on an area corresponding to the first pixel 111. The first light transmittance portion 468 may be disposed on the first pixel 111.

In order to provide a viewing angle less than the first viewing angle, the black matrix 461 may be disposed in a portion of the masking layer 460 corresponding to the set 120 of the second pixel 121. For example, the masking layer 460 may include a second light transmittance portion 469 surrounded by the black matrix 461 on an area corresponding to a pixel included in the set 120 of the second pixel 121. In the second light transmittance portion 469, the black matrix 461 may not be disposed, and a portion of the upper planarization layer 462 may be disposed. The second light transmittance portion 469 may be disposed on a sub-pixel of the second pixel 121. For example, the first light transmittance portion 468 may be formed to correspond to the first pixel 111, but the second light transmittance portion 469 may be formed to correspond to the sub-pixel of the second pixel 121. A width of the second light transmittance portion 469 formed to correspond to the sub-pixel of the second pixel 121 may be less than a width of the first light transmittance portion 468.

The black matrix 461 positioned on the first pixel 111 and the black matrix 461 positioned on the second pixel 121 may be formed of substantially the same black matrix 461. For example, the black matrix 461 may be formed by a negative-type photoresist (Nega PR) process, with one BM portion applied. For example, the BM portion may be applied onto the touch sensitive layer 450, and a mask may be disposed on the applied BM portion. When light is irradiated toward the BM portion covered with the mask, only the BM portion may remain exposed through the pattern penetrating the mask. When the developer contained in the BM portion meets light, the solubility decreases and may not melt. The BM portion of the light-irradiated area may remain to form the black matrix 461, and the BM portion of the remaining area may dissolve and disappear.

According to an embodiment, when the black matrix 461 is formed, an area corresponding to the first pixel 111 may be covered with a mask, and an area corresponding to the second pixel 121 may be covered with a mask in an area corresponding to sub-pixels of the second pixel 121.

The first light transmittance portion 468 formed in the black matrix 461 may be formed as an opening having a diameter corresponding to the first pixel 111 including the subpixels 110-1, 110-2, 110-3, and 110-4, so that the viewing angle of the light emitted from the first pixel 111 may not be limited. The second light transmittance portion 469 may be formed as an opening having a diameter corresponding to each of the sub-pixels 120-1, 120-2, 120-3, and 120-4 of the second pixel 121, thereby determining the viewing angle of light emitted from the second pixel 121. For example, the viewing angle of the sub-pixels 120-1, 120-2, 120-3, and 120-4 of the second pixel 121 may be determined by the path P1 of light emitted from the left side of one sub-pixel of the second pixel 121 and directed to the right side of the second light transmittance portion 469 and the path P2 of light emitted from the right side of the one sub-pixel of the second pixel 121 and directed to the left side of the second light transmittance portion 469.

According to an embodiment, since the black matrix 461 disposed in the area corresponding to the sub-pixel of the second pixel 121 has the second light transmittance portion 469 through which light emitted from the second pixels 121 passes, the viewing angle provided by the second pixel 121 may be less than the viewing angle provided by the first pixel 111.

Referring to FIG. 4A, the touch sensitive layer 450 may include an opening corresponding to the first light transmittance portion 468 and may include an opening corresponding to the second light transmittance portion 469. The touch sensitive electrode 453 of the touch sensitive layer 450 may be disposed under the black matrix 461 surrounding the second light transmittance portion 469. The touch sensitive electrode 453 of the touch sensitive layer 450 may be disposed under the black matrix 461 around the second light transmittance portion 469 on the second pixel 121 providing the second viewing angle. As another example, in order to supplement the touch performance, a portion of the touch sensitive electrode 453 may be disposed under the black matrix 461 around the first light transmittance portion 468 on the first pixel 111 providing the first viewing angle. In order to improve visibility of the touch sensitive electrode 453 on the first pixel 111, a portion of the black matrix 461 on the first pixel 111 may be omitted or may be formed to be thinner than the black matrix 461 on the second pixel 121.

The touch sensitive layer 450 may include a touch sensing portion (e.g., a portion in which the touch sensitive electrode 453, the bridge 454, and the insulation layer 451 are disposed), which is the remaining portion except for the openings (e.g., the first light transmittance portion 468 and the second light transmittance portion 469). The insulation layer 451, the protective layer 452, the touch sensitive electrode 453, and the bridge 454 of the touch sensitive layer 450 may be disposed in the touch sensing portion. The insulation layer 451, the protective layer 452, the touch sensitive electrode 453, and the bridge 454 of the touch sensitive layer 450 are positioned close to the cover layer 470, and when visible from the outside, external light may be reflected by the insulation layer 451, the touch sensitive electrode 453, and the bridge 454, thereby being disposed to be covered by the black matrix 461. In order to reduce the refraction of light by the insulation layer 451 formed of silicon nitride in the area of the touch sensitive layer 450 except for the touch sensitive electrode 453 and the bridge 454 formed of metal, the touch sensitive layer 450 may form an opening in a portion that is not covered by the black matrix 461. An opening corresponding to the first light transmittance portion 468 of the touch sensitive layer 450 may be disposed under the first light transmittance portion 468 and may continuous with the first light transmittance portion 468. An opening corresponding to the second light transmittance portion 469 of the touch sensitive layer 450 may be disposed under the second light transmittance portion 469 and may be continuous with the second light transmittance portion 469.

The display device 100 or the electronic device 101 according to the above-described embodiment may provide a narrow viewing angle depending on a surrounding environment or an input, by disposing the second pixel 121 having a narrower viewing angle than a viewing angle of the first pixel 111. The panel of the display device 100 may include the color filter layer 430 instead of a polarizing plate and thus include the transparent layer 440 to compensate for the reduced thickness of the encapsulation layer 420 to prevent external reflection of light. The panel of the display device 100 including the transparent layer 440 may secure the distance for implementing a narrow viewing angle owing to securing the distance between the black matrix 461 and the pixel layer 410. The second pixel 121 of the panel of the display device 100 may provide a narrow viewing angle, by forming the distance **h1** between the black matrix 461 and the pixel layer 410 longer than the width of the second pixel 121.

According to an embodiment, when the touch sensitive layer 450 is disposed on the encapsulation layer 420, the capacitance between the touch sensitive layer 450 and the pixel layer 410 may increase due to a thinned encapsulation layer 420. To reduce the capacitance of the touch sensitive layer 450, the touch sensitive layer 450 may be disposed on the transparent layer 440. The touch sensitive layer 450 may be disposed on the transparent layer 440 for compensating for the viewing angle, so that it may be configured to compensate for the thinned thickness of the encapsulation layer 420 to achieve a faster response rate of the touch sensitive layer 450.

According to an embodiment, in order to reduce degradation of image quality due to reflection of light and a change in refractive index by the touch sensitive layer 450 disposed on the transparent layer 440, the touch sensitive electrode 453 and the bridge 454 of the touch sensitive layer 450 may be disposed under the black matrix, and the insulation layer 451 and the protective layer 452 of the touch sensitive layer 450 may include openings in portions corresponding to the pixels. The openings may correspond to openings surrounded by the black matrix 461.

In FIG. 4A, the touch sensitive electrode 453 has been described as being disposed on the color filter layer 430, but the disclosure is not limited thereto. A portion (e.g., any one of a Tx electrode and an Rx electrode) of the touch sensitive electrode 453 of FIG. 4A may be disposed on the color filter layer 430, and the other portion may be disposed under the color filter layer 430.

The display device 100 of FIG. 4B may be a display device 100 in which the color filter layer 430 is omitted from the display device 100 of FIG. 4A, and the display device 100 of FIG. 4C may be a display device 100 including the polarized layer 490 instead of the color filter layer 430.

In the display device 100 of FIG. 4B, the color filter layer 430 may be omitted, while the black matrix 432 of the color filter may be maintained. The black matrix 432 may include an opening sized to prevent incident external light from being reflected by the electrode or metal and transmitted to the outside. The pixels of the electronic device 100 of FIG. 4A may be pixels that provide red, green, and/or blue light or pixels that provide single light (e.g., white or blue). The pixels of the electronic device 100 of FIGS. 4B and 4C may be pixels that provide red, green, and/or blue light with the color filter layer 430 omitted.

The display device 100 of FIG. 4C includes the polarized layer 490, which makes it possible to prevent external light from being reflected from a metal or an electrode, and thus the black matrix 432 may be omitted. The polarized layer 490 may be disposed underneath the adhesive layer 465. The position of the polarized layer 490 is not limited thereto. For example, the polarized layer 490 may be disposed under the insulation layer 451 or under the transparent layer 440.

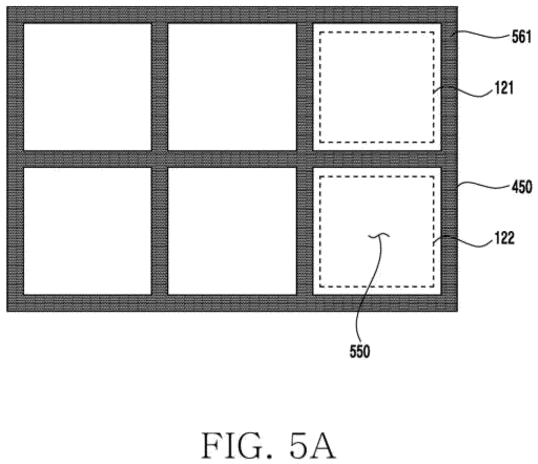

FIG. 5A shows an example touch sensitive layer from which a portion of an insulation layer is removed.

The insulation layer 561 included in the touch sensitive layer 450 may include an opening corresponding to the pixels 121 and 122. The insulation layer 561 may have a refractive index different from that of other layers (e.g., the transparent layer 440, the protective layer 452, and the upper planarization layer 462) formed of a polymer. The refractive index of the insulation layer 561 is different from the refractive index of the transparent layer (e.g., the transparent layer 440 of FIG. 4A), and thus, when light is refracted from an interface surface, the quality of the image transmitted to the outside may deteriorate. In order to eliminate the difference in refractive index between the transparent layer 440 (or other layers) and the insulation layer 561, the insulation layer 561 may include an opening 550 corresponding to the sub-pixels 120-1, 120-2, 120-3, and 120-4 of the second pixel 121.

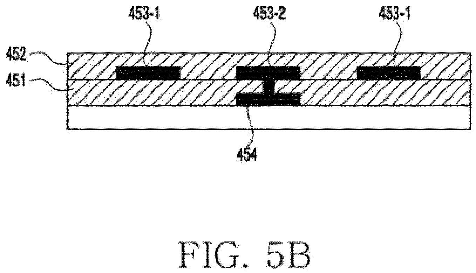

FIG. 5B shows a relationship between a conductive pattern and a bridge in the touch sensitive layer 450.

The touch sensitive layer 450 may include conductive patterns 453-1 and 453-2 printed on the insulation layer 451 and a bridge 454 surrounded by the insulation layer 451. The first conductive pattern 453-1 may be a pattern extending in a first direction of the touch sensor panel, and the second conductive pattern 453-2 may be a pattern extending in a second direction perpendicular to the first direction. At a point where the first conductive pattern 453-1 and the second conductive pattern 453-2 intersect, one of the first conductive pattern 453-1 and the second conductive pattern 453-2 may be avoided without contacting the other conductive pattern through the bridge.

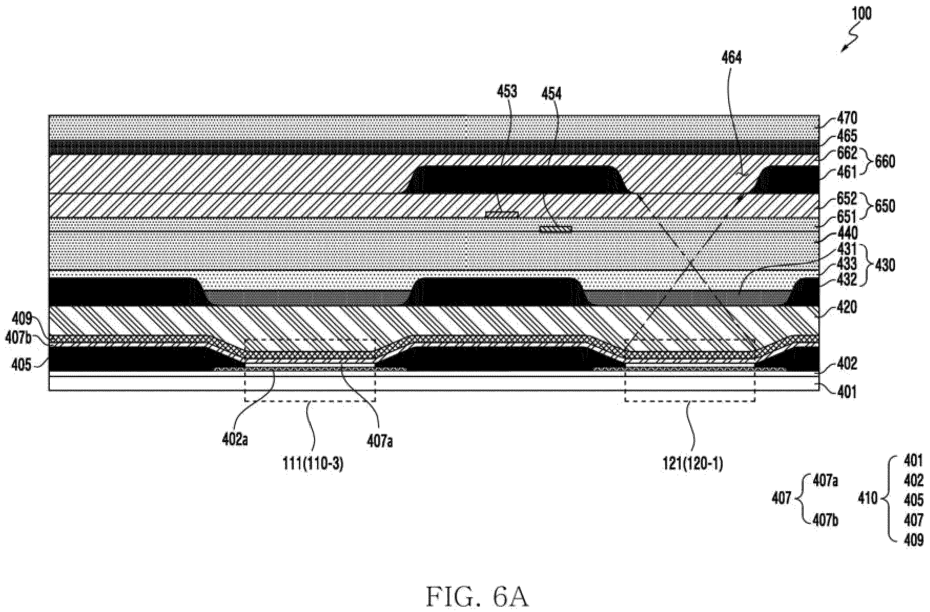

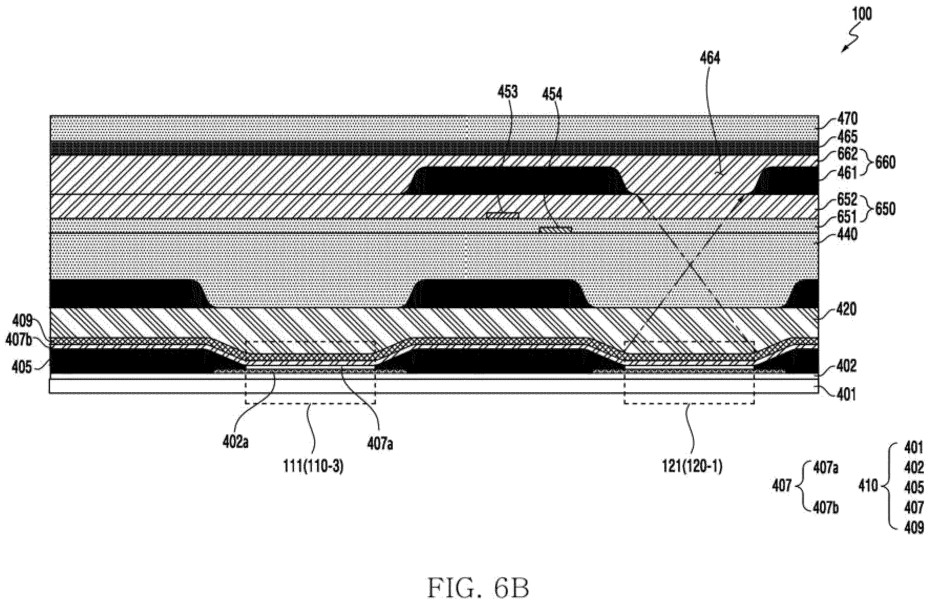

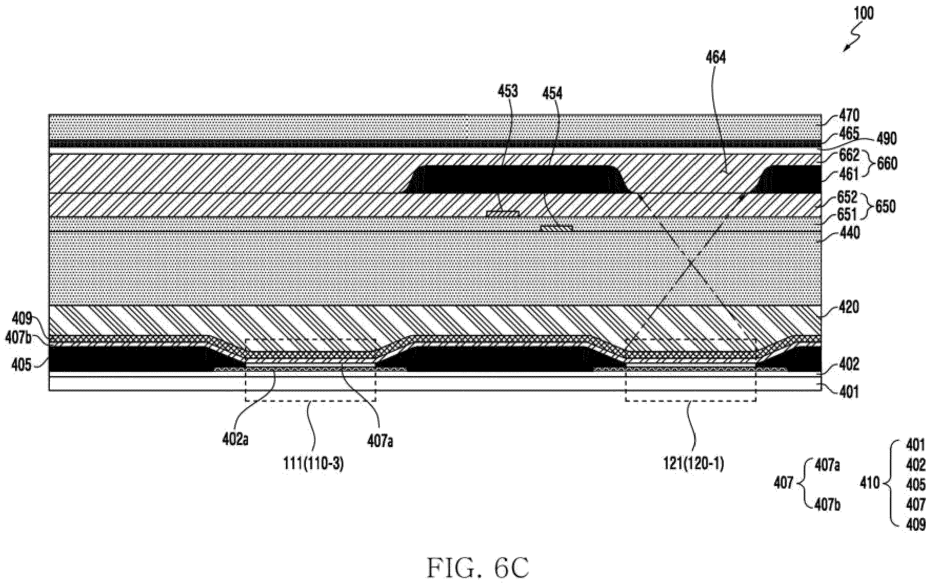

FIGS. 6A, 6B, and 6C illustrate an example display device in which an insulation layer in a touch sensitive layer is formed of the same material as other layers.

Referring to FIGS. 6A, 6B, and 6C, a panel of the display device 100 may include a pixel layer 410, an encapsulation layer 420, a color filter layer 430, a transparent layer 440, a touch sensitive layer 650, a masking layer 660, and a cover layer 470. The pixel layer 410, the encapsulation layer 420, the color filter layer 430, the transparent layer 440, and the cover layer 470 may be the same as or similar to the configurations of the pixel layer 410, the encapsulation layer 420, the color filter layer 430, the transparent layer 440, and the cover layer 470 of FIGS. 4A, 4B, and 4C. Hereinafter, redundant portions of the description of the configurations of the pixel layer 410, the encapsulation layer 420, the color filter layer 430, the transparent layer 440, and the cover layer 470 will be omitted.

The touch sensitive layer 650 may include a layer 651 disposed on the transparent layer 440. The layer 651 may have substantially the same refractive index as that of the transparent layer 440. The quality of image information transmitted by non-refracting light may be improved. The protective layer 652 formed of a polymer material may have substantially the same refractive index as that of the transparent layer 440. The protective layer 652 formed of a polymer material and the upper planarization layer 662 surrounding the black matrix 461 of the masking layer 660 may be formed of a material having a refractive index similar to that of the layer 651. The protective layer 652, the upper planarization layer 662 surrounding the black matrix 461, and the transparent layer 440 may be formed of the same material or may be formed of a material having substantially the same refractive index. When the light emitted from the pixels passes through the layer 651 having substantially the same refractive index as that of the transparent layer 440, the protective layer 652, and the upper planarization layer 662, the light may be transmitted to the outside while maintaining the path of the light.

The touch sensitive electrode 453 of FIG. 6A has been described as being disposed on the color filter layer 430, but the disclosure is not limited thereto. Some (e.g., one of the Tx electrode and the Rx electrode) of the touch sensitive electrode 453 of FIG. 6A may be disposed on the color filter layer 430, and the other may be disposed under the color filter layer 430.

The display device 100 of FIG. 6B may be a display device 100 in which the color filter layer 430 is omitted from the display device 100 of FIG. 6A, and the display device 100 of FIG. 6C may be a display device 100 including the polarized layer 490 instead of the color filter layer 430.

In the display device 100 of FIG. 6B, similarly to FIG. 4B, the color filter layer 430 may be omitted, while the black matrix 432 of the color filter may be maintained. The black matrix 432 may include an opening sized to prevent incident external light from being reflected by the electrode or metal and transmitted to the outside.

The display device 100 of FIG. 6C includes the polarized layer 490 as similar to FIG. 4C, so that it is possible to prevent external light from being reflected from the metal or the electrode, and thus the black matrix 432 may be omitted.

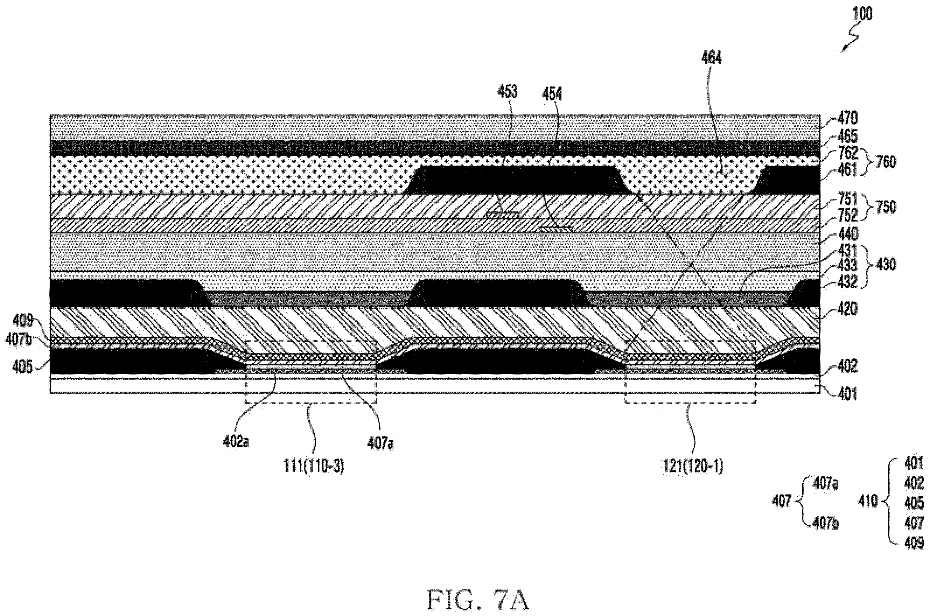

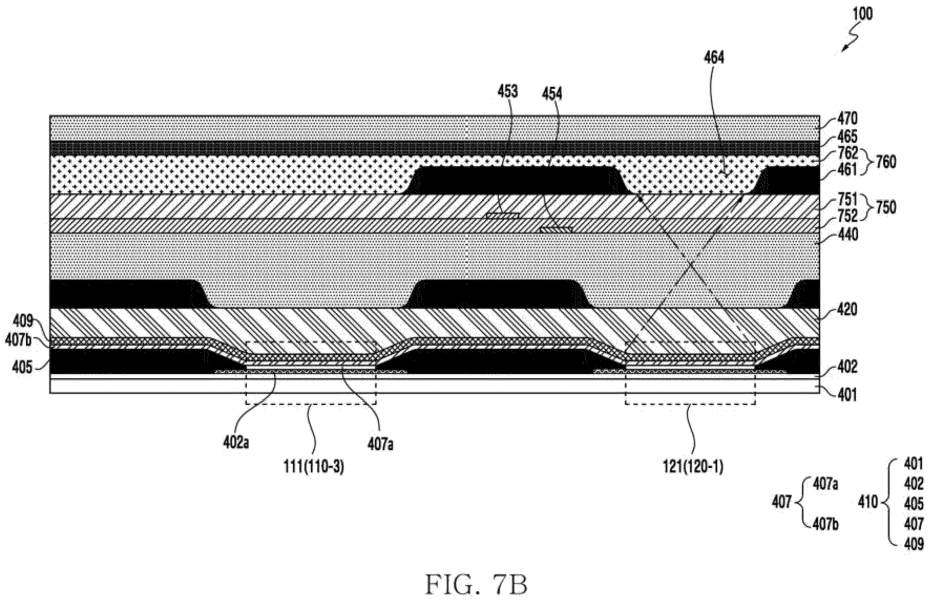

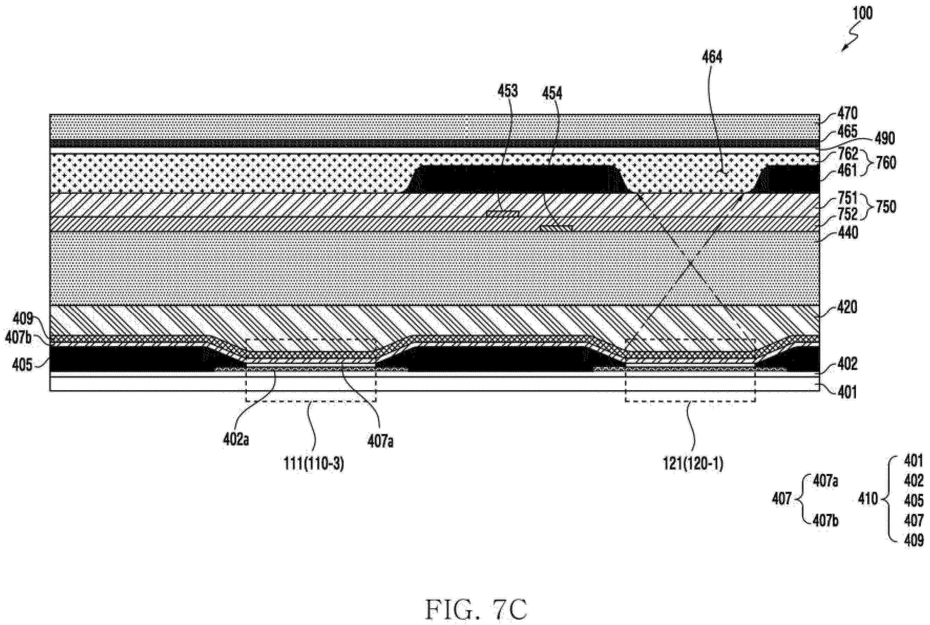

FIGS. 7A, 7B, and 7C illustrate an example display device including a refractive index matching layer for matching a refractive index of light transmitted to the outside.

Referring to FIGS. 7A, 7B, and 7C, a panel of the display device 100 may include a pixel layer 410, an encapsulation layer 420, a color filter layer 430, a transparent layer 440, a touch sensitive layer 750, a masking layer 760, and a cover layer 470. The pixel layer 410, the encapsulation layer 420, the color filter layer 430, the transparent layer 440, and the cover layer 470 may be substantially the same as or similar to the configuration of the pixel layer 410, the encapsulation layer 420, the color filter layer 430, the transparent layer 440, and the cover layer 470 of FIGS. 4A, 4B, 4C, 6A, 6B, and 6C. Hereinafter, redundant portions of the description of the configuration of the pixel layer 410, the encapsulation layer 420, the color filter layer 430, the transparent layer 440, and the cover layer 470 will be omitted.

The touch sensitive layer 750 may include an insulation layer 752 disposed on the transparent layer 440. The insulation layer 752 may be substantially the same as the insulation layer 451 of FIG. 4A.

The upper planarization layer 762 surrounding the protective layer 751 formed of a polymer material and the black matrix 461 of the masking layer 660 may be configured to compensate for the refractive index of refracted light. The upper planarization layer 762 may include a material having a certain refractive index configured to change a path of light refracted at a boundary between the insulation layer 752 and the transparent layer 440 to an original path of light. The upper planarization layer 762 may include a material having the refractive index different from that of the transparent member 470 and the protective layer 751. The upper planarization layer 762 may modify the path of the light emitted from the pixel and refracted at the boundary surface of the layers so that the light is transmitted along a designated path, thereby improving the quality of image information transmitted to the outside. The display device 100 may further include an additional layer for compensating for the refractive index. For example, the additional layer may be added between the protective layer 751 and the transparent layer 440. An additional layer may be added between the protective layer 751 and the upper planarization layer 762. The additional layer may be configured to have the same refractive index as the protective layer 751, the transparent layer 440, and the upper planarization layer 762.

The touch sensitive electrode 453 of FIG. 7A has been described as being disposed on the color filter layer 430, but the disclosure is not limited thereto. Some (e.g., one of the Tx electrode and the Rx electrode) of the touch sensitive electrode 453 of FIG. 7A may be disposed on the color filter layer 430, and the other may be disposed under the color filter layer 430.

The display device 100 of FIG. 7B may be a display device 100 in which the color filter layer 430 is omitted from the display device 100 of FIG. 7A, and the display device 100 of FIG. 7C may be a display device 100 including the polarized layer 490 instead of the color filter layer 430.

Similar to FIGS. 4B and 6B, the display device 100 of FIG. 7B may be in a state in which the color filter layer 430 is omitted and the black matrix 432 of the color filter is maintained. The black matrix 432 may include an opening sized to prevent incident external light from being reflected by the electrode or the metal and transmitted to the outside.

The display device 100 of FIG. 7C includes the polarized layer 490, similar to FIGS. 4C and 6C, which may prevent external light from being reflected from the metal or the electrode, thereby omitting the black matrix 432.

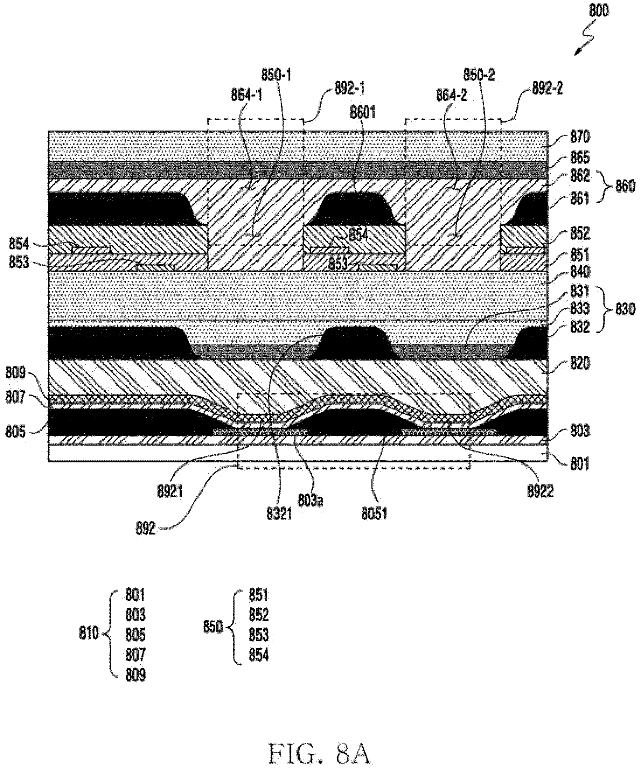

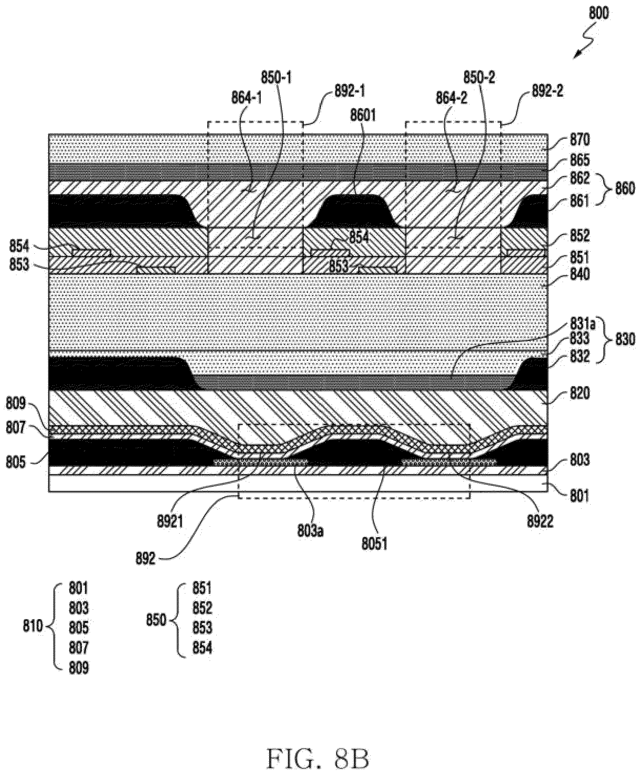

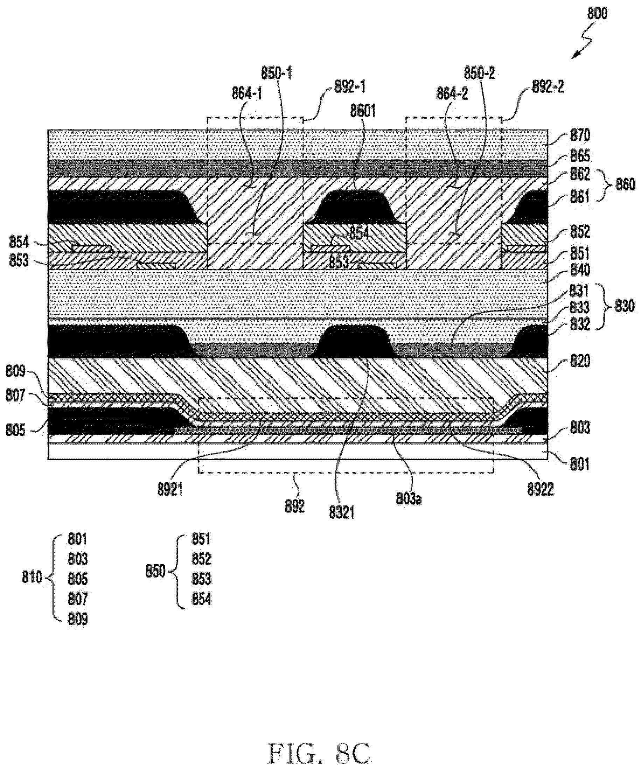

FIGS. 8A, 8B, and 8C illustrate example structures providing micro-pixels for implementing a narrow viewing angle.

Referring to FIGS. 8A, 8B, and 8C, the display device 800 may include a pixel layer 810, an encapsulation layer 820, a color filter layer 830, a transparent layer 840, a touch sensitive layer 850, a masking layer 860, and a transparent layer 870. The pixel layer 810, the encapsulation layer 820, the color filter layer 830, the transparent layer 840, the touch sensitive layer 850, the masking layer 860, the adhesive layer 865, and the transparent layer 870 may be the same as or similar to the pixel layer 410, the encapsulation layer 420, the color filter layer 430, the transparent layer 440, the touch sensitive layers 450, 650, and 750, the masking layers 460, 660, and 760, the adhesive layer 465, and the cover layer 470 of FIGS. 4A, 4B, 4C, 6A, 6B, 6C, 7A, 7B, and 7C.

The pixel layer 810 may include a semiconductor layer 801, a first electrode layer 802, a pixel definition member 805, an organic light emitting layer 807, and a second electrode layer 809. The pixel definition member 805 may further include a partition wall 8051 for dividing the sub-pixel 892 of the second pixel into micro-pixels 8921 and 8922 (e.g., the micro-pixels 120-1a, 120-1b, 120-1c, and 120-1d of FIG. 1B). The partition wall may be disposed between micro-pixels 8921 and 8922 of the sub-pixel 892. The micro-pixels 8921 and 8922 may represent pixels into which the sub-pixel 892 is divided. The micro-pixels 8921 and 8922 corresponding to the sub-pixel 892 may provide light of the same color. The sum of light emitting areas of the micro-pixels 8921 and 8922 included in the sub-pixel 892 of the second pixel providing a narrower viewing angle than that of the first pixel may be equal to or less than the area of the sub-pixels (e.g., the sub-pixels 110-1, 110-2, 110-3, 110-4 of FIGS. 1A and 1B) of the first pixel.

The color filter layer 830 may be disposed on the encapsulation layer 820 disposed on the pixel layer 810. The color filter layer 830 may include a color filter 831 for a color corresponding to the color of light emitted from the sub-pixel 892 making up the pixel layer 810. The color filter layer 830 may include a black matrix 832 that divides the color filter 831. The black matrix 832 may be disposed between the color filters 831. The color filter layer 830 may further include an additional black matrix 8321 to divide the subpixel 892, in addition to the black matrix 832. The additional black matrix 8321 may be disposed at a position corresponding to the partition wall 8051 of the pixel definition member 805 or may overlap the partition wall 8051.

The transparent layer 840 may be disposed on the color filter layer 830. The transparent layer 840 may include a plurality of transparent stacked layers.

The touch sensitive layer 850 may be disposed on the transparent layer 840. The touch sensitive layer 850 may include an insulation layer 851, a protective layer 852, a touch sensitive electrode 854, and a bridge 853.

The masking layer 860 may be disposed on the touch sensitive layer 850. The masking layer 860 may include a black matrix 861 and an upper planarization layer 862. The black matrix 861 of the masking layer 860 may include light transmittance portions 892-1 and 892-2. The light transmittance portions 892-1 and 892-2 may be provided by the openings 864-1 and 864-2 formed in the masking layer 860 and the openings 850-1 and 850-2 formed in the touch sensitive layer 850.

The masking layer 860 (e.g., the masking layer 130 of FIG. 1B) may further include an additional black matrix 8601 in addition to the black matrix 861. The additional black matrix 8601 may be disposed on the partition wall 8051 of the pixel definition member 805. The additional black matrix 8601 may be disposed along a boundary of the micro-pixels 8921 and 8922 in which the sub-pixel 892 is divided. The additional black matrix 8601 may further include openings 864-1 and 864-2 to divide each of a plurality of sub-pixels 892 (e.g., a plurality of sub-pixels 120-1, 120-2, 120-3, and 120-4 of FIG. 2) of the second pixel (e.g., the second pixel 121 of FIG. 2). The micro-pixels 8921 and 8922 divided by the masking layer 860 or the additional black matrix 8601 other than the black matrix 861 may provide the same color. For example, the micro-pixels 8921 and 8922 may be provided in a form in which the sub-pixel 892 providing one color is divided. The sub-pixel 892 may be divided into a plurality (e.g., four) micro-pixels as shown in FIG. 1B. The sum of the area of the light emitting areas of the micro-pixels 8921 and 8922 (e.g., the micro-pixels 120-1a, 120-1b, 120-1c, and 120-1d of FIG. 1B) of the second pixel (e.g., the second pixel 121 of FIG. 1B) may be greater than the area of the light emitting areas of the sub pixels (e.g., the sub pixels 110-1, 110-2, 110-3, and 110-4 of FIG. 1B) of the first pixel (e.g., the first pixel 111 of FIG. 1B). By increasing the area of the divided micro-pixels 8921 and 8922 (or by increasing the size of the organic material), burn-in phenomenon of the display device may be improved.

The insulation layer 851 and the touch sensitive electrode 854 of the touch sensitive layer 850 may be disposed under the black matrix 861 and/or the additional black matrix 8601. The insulation layer 851 and the touch sensitive electrode 854 may not be visible from the outside due to the black matrix 861 and/or the additional black matrix 8601.

Referring to FIG. 8B, the color filter 831a of the color filter layer 830 may be disposed to correspond to the sub-pixel 892, and may not include the additional black matrix (e.g., the additional black matrix 8321) of FIG. 8A corresponding to the partition wall 8051 for separating the micro-pixels 8921 and 8922.

Referring to FIG. 8C, the pixel layer 810 may be configured to be distinguished by the pixel definition member 805 so as to distinguish one sub-pixel 892 in the same manner as the pixel layer 410 of FIG. 4A. The display device 800 may include the additional black matrix 8601 of the masking layer 860 and/or an additional black matrix 8321 of the color filter layer 830 in order to implement a plurality of micro-pixels (e.g., the micro-pixels 8921 and 8922 of FIG. 8A) from one sub-pixel 892.

The micro-pixels 8921 and 8922 obtained by dividing the sub-pixel 892 may be implemented with various structures of the layers in the display device 800.

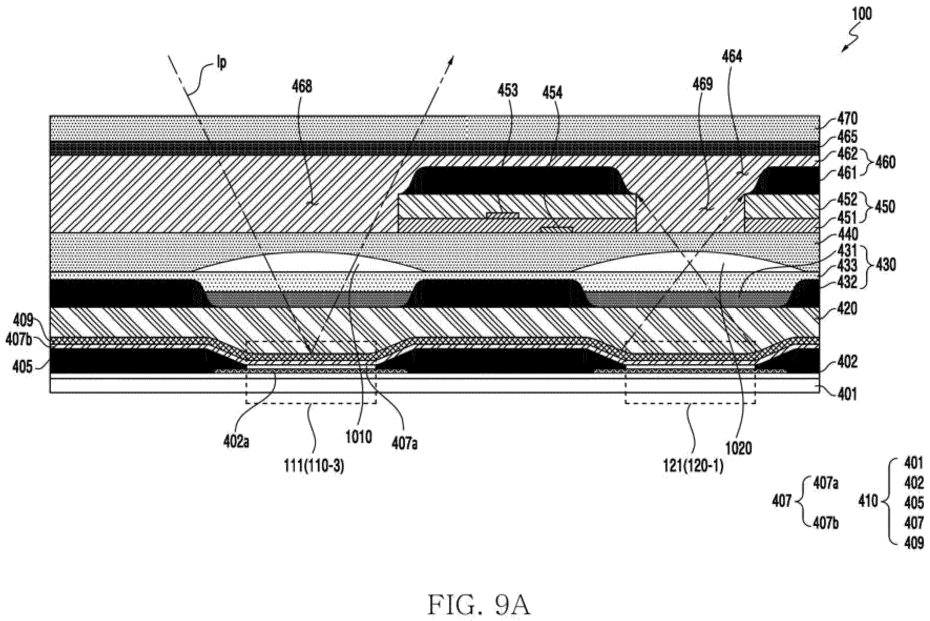

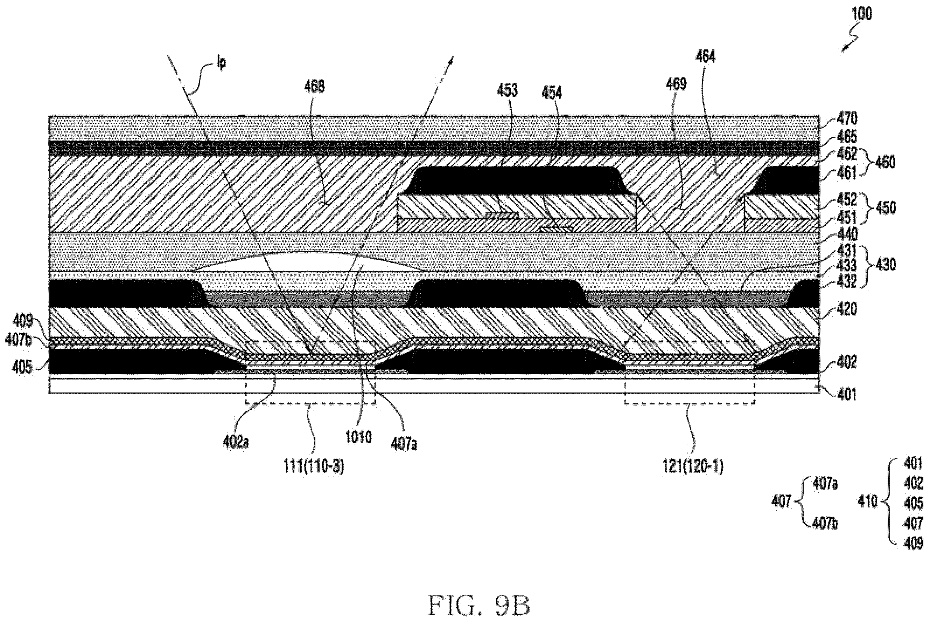

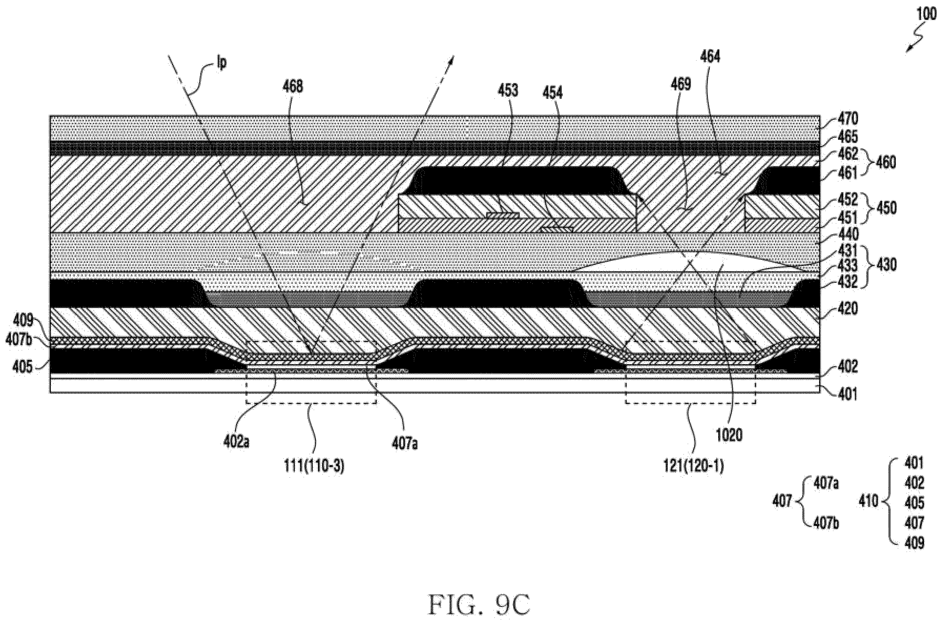

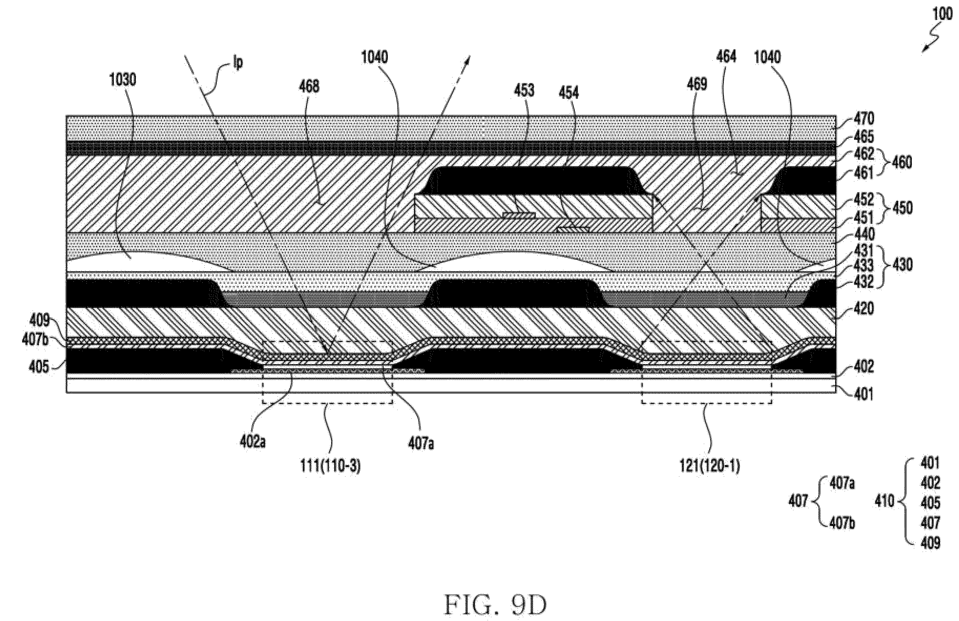

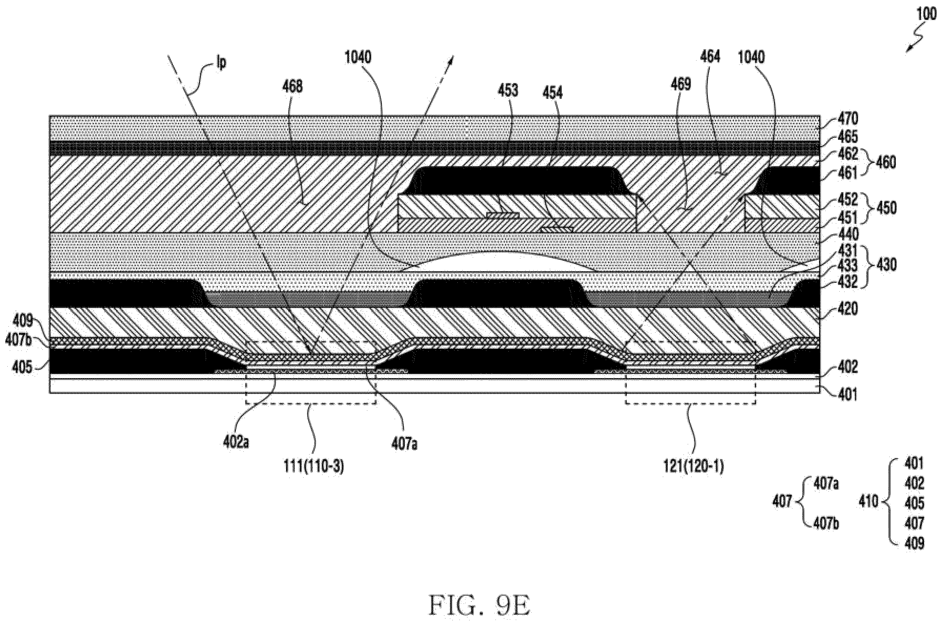

FIGS. 9A, 9B, 9C, 9D, and 9E illustrate example arrangements of an optical member for adjusting a refractive index of light emitted from a first pixel and a second pixel.

Referring to FIGS. 9A, 9B, and 9C, a panel of the display device 100 may include a pixel layer 410, an encapsulation layer 420, a color filter layer 430, a transparent layer 440, a touch sensitive layer 450, a masking layer 460, and a cover layer 470. The pixel layer 410, the encapsulation layer 420, the color filter layer 430, the transparent layer 440, the touch sensitive layer 450, the masking layer 460, and the cover layer 470 may be the same as or similar to the configurations of the pixel layer 410, the encapsulation layer 420, the color filter layer 430, the transparent layer 440, the touch sensitive layer 450, the masking layer 460, and the cover layer 470 of FIGS. 4A, 4B, and 4C. Hereinafter, the description of the configurations of the pixel layer 410, the encapsulation layer 420, the color filter layer 430, the transparent layer 440, the touch sensitive layer 450, the masking layer 460, and the cover layer 470 will be omitted.

Referring to FIG. 9A, the display device may include a first optical member 1010 and a second optical member 1020. The first optical member 1010 may be disposed at a position corresponding to each of the first pixels disposed in the set 110 of the first pixels. The second optical member 1020 may be disposed at a position corresponding to each of the second pixels disposed in the set 120 of the second pixels. The first optical member 1010 and the second optical member 1020 may be disposed on the color filter layer 430. For example, the first optical member 1010 and the second optical member 1020 may be disposed on the lower planarization layer 433 that covers the color filter 431 and the black matrix 432 to provide a flat surface.

The first optical member 1010 may be a lens assembly for forming a wider viewing angle of light emitted from the first pixel 111. For example, the first optical member 1010 may be configured to provide a first viewing angle wider than the viewing angle of light emitted from the first pixel. The second optical member 1020 may be a lens assembly for forming a narrower viewing angle of light emitted from the second pixel 121. For example, the second optical member 1020 may be configured to provide a second viewing angle narrower than the viewing angle of light emitted from the second pixel.

The first optical member 1010 and the second optical member 1020 may be disposed in the lower planarization layer 433 corresponding to the color filter 431 of the color filter layer 430 to adjust the path of light emitted from the pixels. The first optical member 1010 and the second optical member 1020 may be disposed on the light emitting area of the set 110 or 120 of pixels to adjust the path of light emitted from the pixels.

Referring to FIG. 9B, the display device may include a first optical member 1010 of the first optical member 1010 and the second optical member 1020. The first optical member 1010 is a lens assembly for forming a wider viewing angle of light emitted from the first pixel 111, and may be configured to be disposed on the first pixel to provide a wider viewing angle than the viewing angle of light emitted from the second pixel.

Referring to FIG. 9C, the display device may include a second optical member 1020 of the first optical member 1010 and the second optical member 1020. The second optical member 1020 is a lens assembly for forming a narrower viewing angle of light emitted from the second pixel 121, and may be configured to be disposed on the second pixel to provide a narrower viewing angle than the viewing angle of light emitted from the first pixel 111.

The display device including the first optical member 1010 and/or the second optical member 1020 may adjust the viewing angle of light emitted from each pixel, thereby increasing a difference in viewing angle between a first mode providing a wide viewing angle and a second mode providing a narrow viewing angle. Accordingly, it is possible to reduce an area or range in which another user other than the user may view image information in the screen of the display device.

FIGS. 9A, 9B, and 9C illustrate that an optical member (or lens) is disposed on a light emitting area of a pixel, but the disclosure is not limited thereto.

Referring to FIGS. 9D and 9E, the optical member (or lens) may be disposed not to overlap the light emitting area of the pixels. For example, on the color filter layer 430, the optical members 1030 and 1040 may be disposed on the black matrix portion 432 and not disposed on the color filter 431. The optical member disposed on the black matrix portion 432 may guide a path of light emitted and transmitted from the first pixel or the second pixel to pass through the first light transmittance portion 468 or the second light transmittance portion 469 (or the light transmittance portion formed by the first opening or the second opening). As another example, the optical path may be formed to pass through the first light transmittance portion 468 or the second light transmittance portion 469 (or the first opening or the second opening), by making different a refractive index of a portion of some layer of the layers composing the display device 100 or 800. As shown in FIG. 9E, a part of the optical members 1030 and 1040 may be omitted. Although the first optical member 1030 disposed in the black matrix portion surrounding the sub-pixel 110-3 of the first pixel 111 among the optical members 1030 and 1040 is illustrated as being omitted, the second optical member 1040 disposed in the black matrix portion surrounding the sub-pixel 120-1 of the second pixel 121 may be omitted.

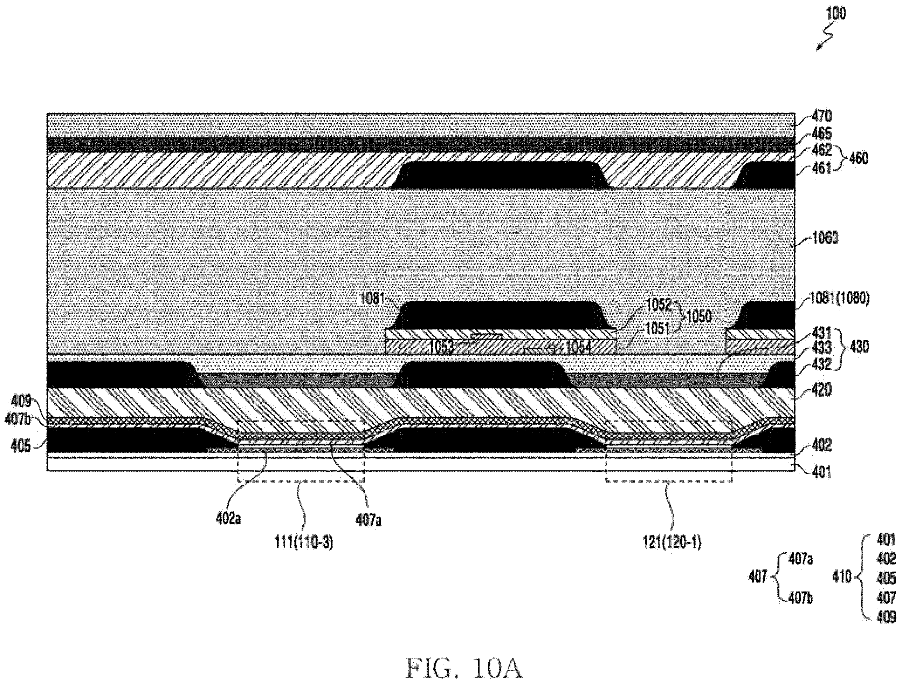

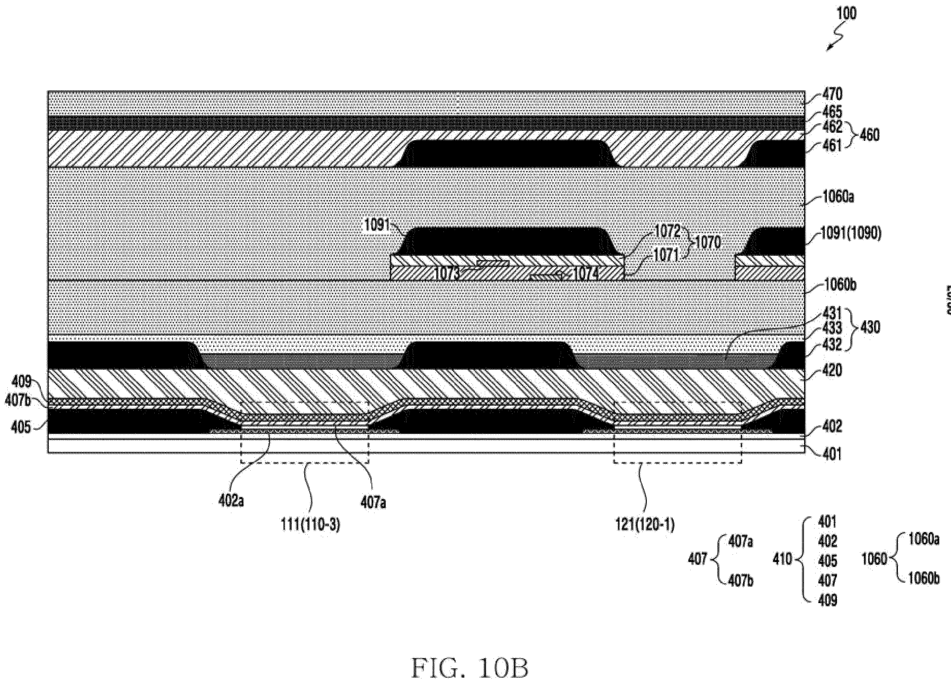

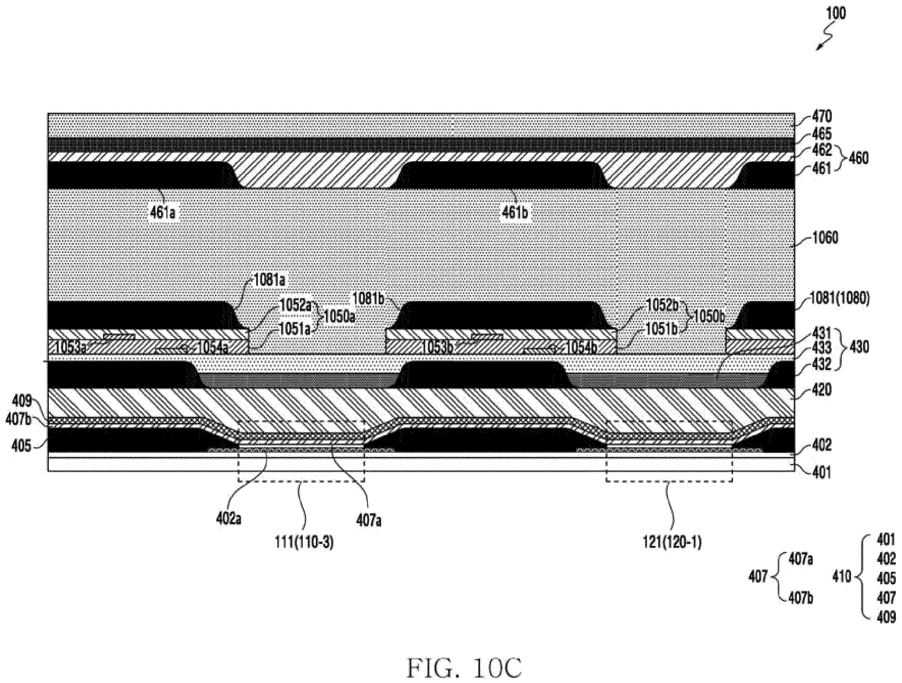

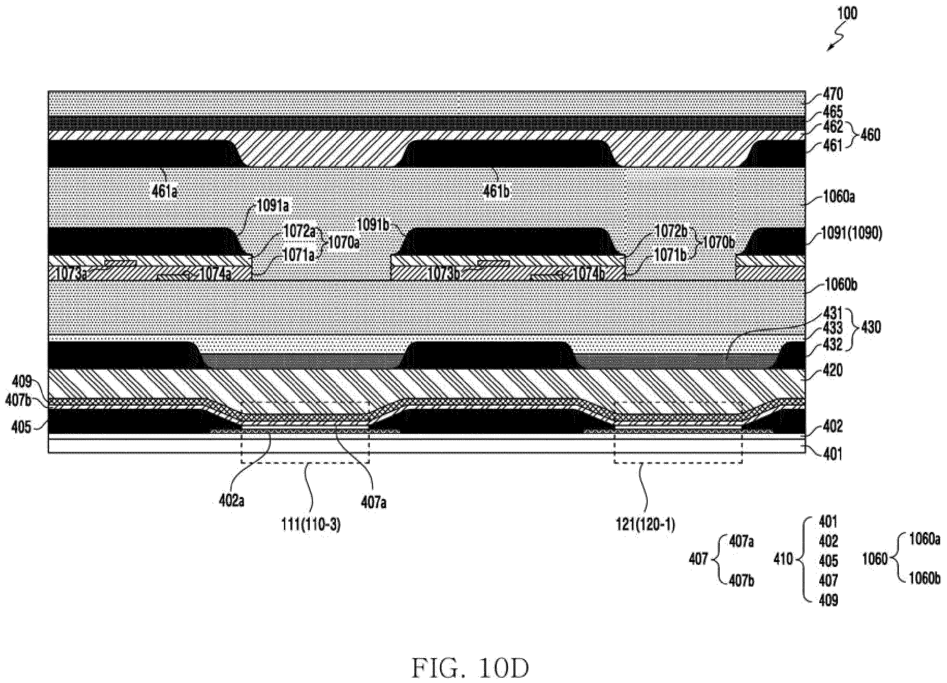

The touch sensitive electrode 453 of FIGS. 9A, 9B, 9C, 9D, and 9E has been described as being disposed on the color filter layer 430, but the disclosure is not limited thereto. Some (e.g., one of the Tx electrode and the Rx electrode) of the touch sensitive electrodes 453 of FIGS. 4A, 4B, and 4C may be disposed on the color filter layer 430, and the other may be disposed under the color filter layer 430. The arrangement of the touch sensitive layer 450 including the touch sensitive electrode 453 will be described with reference to FIGS. 10A, 10B, 10C, and 10D.

FIG. 10A illustrates an arrangement of an example touch sensitive layer disposed between a transparent layer and a lower planarization layer. FIG. 10B illustrates an arrangement of a touch sensitive layer interposed in a transparent layer. FIGS. 10C and 10D illustrate an arrangement of an example touch sensitive layer including a conductive pattern disposed on a first pixel.

Referring to FIGS. 10A, 10B, 10C, and 10D, a panel of the display device 100 may include a pixel layer 410, an encapsulation layer 420, a color filter layer 430, a masking layer 460, and a cover layer 470. The pixel layer 410, the encapsulation layer 420, the color filter layer 430, the masking layer 460, and the cover layer 470 may be the same as or similar to the configurations of the pixel layer 410, the encapsulation layer 420, the color filter layer 430, the masking layer 460, and the cover layer 470 of FIG. 4A. A description of the configurations of the pixel layer 410, the encapsulation layer 420, the color filter layer 430, the masking layer 460, and the cover layer 470 will be omitted.

Referring to FIG. 10A, the display device 100 may include an additional masking layer 1080. The additional masking layer 1080 may include a black matrix 1081. The additional masking layer 1080 may be disposed on the color filter layer 430. The additional masking layer 1080 may be disposed on the lower planarization layer 433 of the color filter layer 430. The additional masking layer 1080 may be surrounded by the lower planarization layer 433 and a transparent layer 1060. The touch sensitive layer 1050 may be disposed between the additional masking layer 1080 and the color filter layer 430. The touch sensitive layer 1050 may be covered by the black matrix 1081 of the additional masking layer 1080. The black matrix 1081 of the additional masking layer 1080 may be disposed at a position corresponding to the black matrix 461 of the masking layer 460. For example, the light transmittance portion of the black matrix 1081 of the additional masking layer 1080 may be disposed to substantially overlap the light transmittance portion (e.g., the light transmittance portions 468 and 469 of FIG. 4A) of the masking layer 460. For example, the light transmittance portion of the black matrix 1081 of the additional masking layer 1080 and the light transmittance portion of the masking layer 460 may be formed to correspond to the light emitting area of the second pixel 121. According to an embodiment, the touch sensitive layer 1050 may be disposed on the lower planarization layer 433 of the color filter layer 430. The touch sensitive layer 1050 may include an insulation layer 1051 on which a touch sensitive electrode 1053 is disposed and a protective layer 452 for protecting the touch sensitive electrode 1053. The touch sensitive electrode 1053 and a bridge 1054 may be formed on the lower planarization layer 433 of the color filter layer 430 and may be integrally formed with the display panel. The bridge 1054 may be surrounded by the insulation layer 1051. The configuration of the touch sensitive electrode 1053 and the bridge 1054 may be substantially the same as or similar to that of the touch sensitive electrode 453 and the bridge 454 of FIG. 4A, except for their disposed position. The touch sensitive layer 1050 may be disposed under the black matrix 1081 of the masking layer 1080 to prevent the touch sensitive layer 1050 from being viewed from the outside of the display device 100.

Referring to FIG. 10B, the display device 100 may include an additional masking layer 1090. The additional masking layer 1090 may include a black matrix 1091. The additional masking layer 1090 and a touch sensitive layer 1070 may be surrounded by the transparent layer 1060. For example, the additional masking layer 1090 and the touch sensitive layer 1070 may be embedded in the transparent layer 1060. The touch sensitive layer 1070 may be disposed under the additional masking layer 1090. The touch sensitive layer 1070 may be covered by a black matrix 1091 of the additional masking layer 1090. The black matrix 1091 of the additional masking layer 1090 may be disposed at a position corresponding to the black matrix 461 of the masking layer 460. For example, the light transmittance portion of the black matrix 1091 of the additional masking layer 1090 may be disposed to substantially overlap the light transmittance portion (e.g., the light transmittance portions 468 and 469 of FIG. 4A) of the masking layer 460. For example, the light transmittance portion of the black matrix 1091 of the additional masking layer 1090 and the light transmittance portion of the masking layer 460 may be formed to correspond to the light emitting area of the second pixel 121.

The transparent layer 1060 surrounding the additional masking layer 1090 and the touch sensitive layer 1070 may be formed of a plurality of layers. The additional masking layer 1090 and the touch sensitive layer 1070 may be surrounded by an upper transparent layer 1060a and a lower transparent layer 1060b. The transparent layer 1060 is not limited to two layers, and may be formed of two or more layers. According to an embodiment, the touch sensitive layer 1070 may be disposed on the lower transparent layer 1060b. The touch sensitive layer 1070 may include an insulation layer 1071 on which a touch sensitive electrode 1073 is disposed and a protective layer 1072 for protecting the touch sensitive electrode 1073. A bridge 1074 may be surrounded by the insulation layer 1071. The configuration of the touch sensitive electrode 1073 and the bridge 1074 may be substantially the same as or similar to those of the touch sensitive electrode 453 and the bridge 454 of FIG. 4A, except for their disposed position. The touch sensitive layer 1070 may be disposed under the black matrix 1091 of the additional masking layer 1090 to prevent the touch sensitive layer 1070 from being viewed from the outside of the display device 100.

When the additional masking layers 1080 and 1090 are disposed in the transparent layer 1060, as shown in FIGS. 10A and 10B, the touch sensitive layers 1050 and 1070 may be disposed under the additional masking layers 1080 and 1090.

Referring to FIG. 10C, the additional masking layer 1080 may further include a first additional black matrix 1081a for distinguishing the sub-pixel 110-3 of the first pixel 111 and a second additional black matrix 1081b for distinguishing the sub-pixel 120-1 of the second pixel 121. The additional masking layer 1080 may be disposed on the color filter layer 430 similarly to FIG. 10A. The additional masking layer 1080 may be disposed on the lower planarization layer 433 of the color filter layer 430. The touch sensitive layers 1050a and 1050b may be visually hidden by the first additional black matrix 1081a and the second additional black matrix 1081b of the additional masking layer 1080. The touch sensitive layers 1050a and 1050b may include a first touch sensitive electrode 1053a, a second touch sensitive electrode 1053b, a first bridge 1054a, and a second bridge 1054b. The first touch sensitive electrode 1053a and the first bridge 1054a may be disposed under the first additional black matrix 1081a. The second touch sensitive electrode 1053b and the second bridge 1054b may be disposed under the second additional black matrix 1081b. A portion 1050a of the touch sensitive layer disposed under the first additional black matrix 1081a may include a first insulation layer 1051a surrounding the first bridge 1054a and a first protective layer 1052a surrounding the first touch sensitive electrode 1053a. A portion 1050b of the touch sensitive layer disposed under the second additional black matrix 1081b may include a second insulation layer 1051b surrounding the second bridge 1054b and a second protective layer 1052b surrounding the second touch sensitive electrode 1053b.

The masking layer 460 may further include a first black matrix 461a for distinguishing the subpixel 110-3 of the first pixel 111 and a second black matrix 461b for distinguishing the subpixel 120-1 of the second pixel 121. Each of the first black matrix 461a and the second black matrix 461b may be disposed at a position corresponding to the first additional black matrix 1081a and the second additional black matrix 1081b. For example, the first black matrix 461a and the second black matrix 461b may be disposed, on the transparent layer 1060, to overlap the first additional black matrix 1081a and the second additional black matrix 1081b, when the display device 100 is viewed from above.

Although it has been described that the masking layer 460 includes the first black matrix 461a, the first black matrix 461a may be omitted and the second black matrix 461b may be included in the masking layer 460.

Referring to FIG. 10D, the additional masking layer 1090 may further include a first additional black matrix 1091a for distinguishing the sub-pixel 110-3 of the first pixel 111 and a second additional black matrix 1091b for distinguishing the sub-pixel 120-1 of the second pixel 121.

The additional masking layer 1090 may further include a first additional black matrix 1091a for distinguishing the sub-pixel 110-3 of the first pixel 111 and a second additional black matrix 1091b for distinguishing the sub-pixel 120-1 of the second pixel 121. Similar to FIG. 10B, the additional masking layer 1090 and the touch sensitive layers 1070a and 1070b may be surrounded by the transparent layer 1060. The touch sensitive layers 1070a and 1070b may be disposed under the additional masking layer 1090. The touch sensitive layers 1070a and 1070b may be hidden by the black matrices 1091a and 1091b of the additional masking layer 1090. The additional masking layer 1090 may include a first additional black matrix 1091a and a second additional black matrix 1091b. The first additional black matrix 1091a may be disposed at a position corresponding to the first black matrix 461a of the masking layer 460. For example, the light transmittance portion of the black matrix 1091 of the additional masking layer 1090 may be disposed to substantially overlap the light transmittance portion (e.g., the light transmittance portions 468 and 469 of FIG. 4A) of the masking layer 460. For example, the light transmittance portion of the first additional black matrix 1091a and the light transmittance portion of the first black matrix 461a of the additional masking layer 1090 surrounding the sub-pixel 110-3 of the first pixel 111 may be formed to correspond to the light emitting area of the first pixel 111. The light transmittance portion of the second additional black matrix 1091b and the light transmittance portion of the second black matrix 461b of the additional masking layer 1090 surrounding the sub-pixel 120-1 of the second pixel 121 may be formed to correspond to the light emitting area of the second pixel 121.

The transparent layer 1060 surrounding the additional masking layer 1090 and the touch sensitive layers 1070a and 1070b may be formed of a plurality of layers. The additional masking layer 1090 and the touch sensitive layers 1070a and 1070b may be surrounded by the upper transparent layer 1060a and the lower transparent layer 1060b. The transparent layer 1060 is not limited to these two layers, and may be formed of two or more layers. The touch sensitive layers 1070a and 1070b may be visually hidden by the first additional black matrix 1091a and the second additional black matrix 1091b of the additional masking layer 1090. The touch sensitive layers 1070a and 1070b may include a first touch sensitive electrode 1073a, a second touch sensitive electrode 1073b, a first bridge 1074a, and a second bridge 1074b. The first touch sensitive electrode 1073a and the first bridge 1074a may be disposed under the first additional black matrix 1071a. The second touch sensitive electrode 1073b and the second bridge 1074b may be disposed under the second additional black matrix 1091b. A portion 1070a of the touch sensitive layer disposed under the first additional black matrix 1091a may include a first insulation layer 1071a surrounding the first bridge 1074a and a first protective layer 1072a surrounding the first touch sensitive electrode 1073a. A portion 1070b of the touch sensitive layer disposed under the second additional black matrix 1091b may include a second insulation layer 1071b surrounding the second bridge 1074b and a second protective layer 1072b surrounding the second touch sensitive electrode 1073b.

The masking layer 460 may further include a first black matrix 461a for distinguishing the subpixel 110-3 of the first pixel 111 and a second black matrix 461b for distinguishing the subpixel 120-1 of the second pixel 121. The masking layer 460 may be the same as or similar to that shown in FIG. 10C.

In an embodiment, although the masking layer 460 is illustrated as including the first black matrix 461a, this first black matrix 461a may be omitted, and the second black matrix 461b may be included in the masking layer 460.

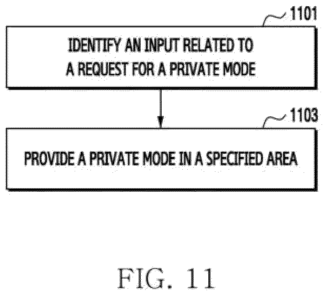

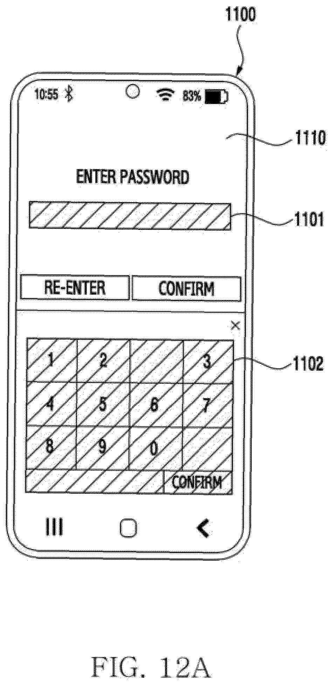

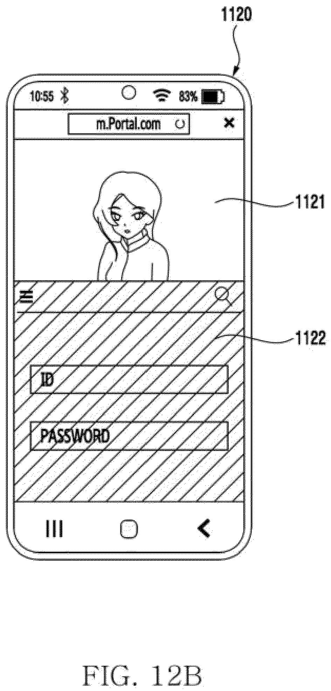

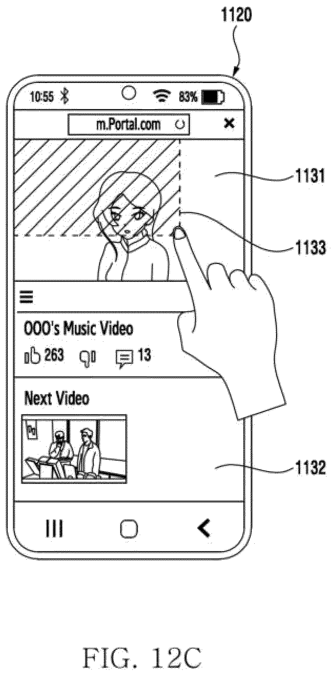

FIG. 11 is a flowchart illustrating an operation of providing a portion of a display area of a display in a private mode. FIGS. 12A, 12B, and 12C illustrate an example in which a private display is applied to a portion of a display area of a display.

Referring to FIG. 11, in operation 1101, a processor (e.g., the processor 1320 of FIG. 13) may identify an input related to a request for a private mode.

The private mode may indicate a mode for providing a second viewing angle less than a first viewing angle, using the display devices 100 and 800 of FIGS. 1 to 10D. A normal mode for providing the first viewing angle may be a mode for providing a clear image quality and a wide viewing angle to share visual information with people around a user. The private mode may be a mode for providing the second viewing angle so that visual information may be obtained only by the user within a range of the second viewing angle. The processor (e.g., the processor 1320 or the display driver IC 1430) may lower the operating frequency (or refresh rate) of the private mode than the operating frequency of the normal mode.

The input may indicate an input by a user or reception of a signal transmitted to a processor. The user's input may be provided via a setting window or an input button. For example, the processor may provide the private mode for providing the second viewing angle, through an input of the user selecting the private mode. The private mode may include a mode in which the entire display area of the display is provided in the private mode, or a mode in which a portion of the display area is provided in the private mode. For example, in case where a portion of the display area is provided in the private mode, the processor may be configured to provide a luminance or an operating frequency of a boundary area between the display area provided in the normal mode and the display area provided in the private mode as values between the luminance or the operating frequency of the general mode and the luminance or driving frequency of the private mode.

The signals transmitted to the processor of the input may include a time preset by the user or a usage pattern of the user. For example, the processor may be configured to provide the private mode within a range of the time preset by the user or the usage pattern of the user. The user's usage pattern may include a state of moving to a specific place, a user's behavior in a specific time zone, or a usage pattern learned by an electronic device.

The signal transmitted to the processor of the input may include a signal according to a state of the electronic device (e.g., the electronic device 101 of FIGS. 1A and 1B or the electronic device 1301 of FIG. 13). For example, when the electronic device is a foldable electronic device (e.g., the electronic devices 101b, 101c, and 101d of FIG. 1A), the signal may be an input according to a folding state, an unfolding state, and an intermediate state of the electronic device. The folding state may be a state in which the electronic device is fully folded, and the unfolding state may be a state in which the electronic device is unfolded. The intermediate state may include a state in which an angle between the housings of the electronic device exceeds 0 degrees and is less than approximately 180 degrees. When the processor identifies that the electronic device is in the unfolding state or the intermediate state, it may provide the private mode via operation 1103. The processor may adjust the viewing angle by driving the first pixel (e.g., the first pixel 111 of FIGS. 1A and 1B) and the second pixel (e.g., the second pixel 121 of FIGS. 1A and 1B). The processor may be configured to provide the private mode by driving only the second pixel in the unfolding state, and provide the private mode by driving a part of the first pixel and the second pixel in the intermediate state.

The signal transmitted to the processor of the input may include a signal according to an environment around the electronic device. For example, the processor may obtain location information of the electronic device. The processor may be configured to provide the private mode at a predesignated location (e.g., a location designated by a user or a public place) based on the location information. For example, the processor may selectively provide either one of the private mode and a general mode based on information obtained using various sensors (e.g., a camera, a microphone, or an illuminance sensor) of the electronic device. The processor may be configured to provide the private mode based on identifying that the surrounding environment is crowded with people other than the user, from an image acquired via a camera (e.g., an image including people other than the user) or audio acquired via a microphone (e.g., audio with a high sound pressure level or audio with voices of other people than the user). The processor may be configured to provide the private mode, when the brightness of the screen is relatively high, based on illuminance information obtained through the illuminance sensor. For example, when the luminance level around the electronic device is relatively low, the electronic device may provide the private mode, where the screen has a high brightness that makes it easy for people in the vicinity to identify the screen.

In operation 1103, the processor may provide a private mode in a specified area, based on identifying a request for the private mode.

The specified area may be set in system or application settings. For example, providing of the private mode in a specified area of the display area may include a keypad portion, an input window portion, a text field, or the like that displays a portion where input information of a user is exposed.

The processor may adaptively designate a specified area. Such an adaptive designation may determine the specified area based on the content provided in the display area of the display. The processor may determine an area to provide the private mode based on the image or text provided on the display area of the display. For example, the processor may, based on information of a portrait image included in an image provided on the display area, provide a portion on which the portrait image is displayed, in a private mode. When the portrait image includes a predesignated person (e.g., a person designated by a user or a person included in images of a reference ratio or more among images stored in the electronic device), the processor may provide a face of the person or a display area corresponding to the person, in a private mode. The processor may apply a different provision of the private mode according to an executed application. For example, the processor may apply the private image to a preview image of a Gallery or a camera application, and may not apply the private image to images transmitted from an external source, such as a browser. The application to which the private mode is applied may be set by a user or may be set by a processor.

The processor may be configured to provide a first display area in a first mode and provide a second display area in a second mode, which is a private mode, while operating in a plurality of display areas divided. If necessary, the processor may provide both the first display area and the second display area in the first mode, or may provide both the first display area and the second display area in the second mode.

The processor may determine a specified area for providing the private mode, based on the presence or absence of personal information or an application executed. The application may be set upon an input or installation of a user related to operating in the private mode. When the application is executed, the application may be executed in the first mode or the second mode based on a set value. The processor may be configured to provide an input or keypad portion, such as e.g., mobile banking or login windows that provide personal information, in a private mode.

Referring to FIG. 12A, the second mode having a narrow viewing angle may be provided in some portions 1101 and 1102 of a display area 1110 in a display 1100 (e.g., the display device 100 of FIGS. 1A and 1B).

For example, the second mode may be provided to the portions 1101 and 1102 that may expose information a user does not want to be exposed to other persons, such as e.g., personal information, a password, or a password input window, and the first mode may be provide to the remaining portions of the display area 1110.

The display 1100 may be configured to provide a wide viewing angle by activating both the first pixel and the second pixel in the remaining portion of the display area 1110 providing the first mode, and to provide a narrow viewing angle by activating only the second pixel or activating a portion of the second pixel and the first pixel in some areas 1101 and 1102 of the display area 1110 providing the second mode.

The portion in which the second mode is provided may be configured to be automatically set or set by a user input. Hereinafter, description will be made with reference to FIGS. 12B and 12C.

Referring to FIG. 12B, in a state 1120 in which information is provided in a display area (e.g., the display area 1110 of FIG. 12A) of the display, at least one processor (e.g., the processor 1320 of FIG. 13) may be configured to identify a first portion 1121 providing first information and a second portion 1122 providing second information. The first portion 1121 may be a portion for indicating general visual information, and the second portion 1122 may be a portion for displaying security information, such as personal information of a user and a password of the user. Positions of the first portion 1121 and the second portion 1122 may be arranged in a various manner based on a configuration of a screen or an application to be executed. Based on the identification, the processor 1320 may activate both the first pixel and the second pixel in the first portion 1121 through display driving circuitry (e.g., the display driving circuitry 1430 of FIG. 14). Based on the identification, the processor 1320 may activate a portion of the first pixel and the second pixel in the second portion 1122 through the display driver circuit. For example, the processor 1320 may be configured to activate only the second pixel or activate the entire second pixel and a part of the first pixel in the second portion 1122.

Referring to FIG. 12C, in the state 1120 in which information is provided in the display area of the display, the second mode may be provided in a portion 1133 specified by a user input. For example, of the first portion 1131 and the second portion 1132 where a split screen or other contents are provided, if the user wishes to obscure visual information (or an image) provided through the first portion 1131, the user may specify the portion 1133 within the first portion 1131, via a drag or touch input in the first portion 1131. For example, a plurality of portions 1133 for providing the second mode may be selected through a user's drag or touch input. The portion 1133 for providing the second mode via the user's drag or touch input may be selected as the entire first portion 1131. The first portion 1131 and the second portion 1132 may be portions in which respective applications are split and displayed. The execution application of the first portion 1131 and the execution application of the second portion 1132 may be provided in different modes according to a user's input or setting. For example, both the first portion 1131 and the second portion 1132 may be provided in the first mode, or they may be provided in the second mode, which is a private mode, or one portion (e.g., the first portion 1131) may be provided in the first mode while the other portion (e.g., the second portion 1132) may be provided in the second mode. The processor may identify the specified portion 1133 through a user's input. The processor may be configured to provide the second mode in the specified portion 1133 and provide the first mode in the remaining portion, based on the identified portion 1133. For example, based on the identification, the processor 1320 may activate a portion of the first pixel and a portion of the second pixel in the specified portion 1133 via the display driver circuit. For example, the processor 1320 may be configured to provide the second mode by activating only the second pixel or activating the entire second pixel and a portion of the first pixel, in the specified portion 1133. The processor 1320 may be configured to provide the first mode by activating the first pixel and the second pixel in the remaining portion of the display area 1120 except for the specified portion 1133.

According to an embodiment, a display devie displays images on a display.

The display device may selectively adjust the viewing angle of images displayed on the display. For example, the display device may provide a narrow viewing angle based on a surrounding environment or an input.

The display device may provide a fast response speed of the touch sensitive layer through the touch sensitive layer disposed on the transparent layer for compensating for the viewing angle.

According to an embodiment, it is possible to reduce degradation of image quality due to the reflection of light and a change in refractive index by the touch sensitive layer 450 disposed on the transparent layer 440.

The technical problems to be addressed in the disclosure are not limited to those mentioned above, and any other technical problems not mentioned herein may be clearly understood by those having the ordinary knowledge in the technical field to which the disclosure belongs.

According to the above-described embodiment, a display device 100 (e.g., the display device 100 of FIG. 4A) includes a pixel layer 410 (e.g., the first pixel layer 410 of FIG. 4A) including a plurality of pixels including a first pixel (e.g., the first pixel 111 of FIGS. 1A and 1B) and a second pixel (e.g., the second pixel 121 of FIGS. 1A and 1B) positioned adjacent to the first pixel 111, a masking layer (e.g., the masking layer 460 of FIG. 4A) including black matrix portions (e.g., the black matrix 461 of FIG. 4A) and light transmittance portions (e.g., the first light transmittance portion 468 and the second light transmittance portion 469 of FIG. 4A) disposed such that light from the first pixel 111 is emitted with a first viewing angle limited by a portion of the black matrix portions 461 and light from the second pixel 121 is emitted with a second viewing angle limited by a portion of the black matrix portions 461, the second viewing angle being narrower than the first viewing angle, a transparent layer (e.g., the transparent layer 440 of FIG. 4A) disposed between the pixel layer and the masking layer such that the masking layer 460 is spaced apart by a designated (or specified) distance from the pixel layer 410 for the second viewing angle, and a touch sensitive layer (e.g., a touch sensitive panel (TSP) layer and/or the touch sensitive layer 450 of FIG. 4A) disposed between the masking layer 460 and the transparent layer 440 and including an insulation layer 451 and a plurality of touch sensitive electrodes 453, wherein the insulation layer 451 of the touch sensitive layer may be omitted below the light transmittance portions 468 and 469 of the masking layer 460. As such, the implementation of narrow viewing angle is effectively realized by securing the distance between the pixel and the masking layer (e.g., through the transparent layer). Meanwhile, the capacitance can be decreased and accordingly, the response speed of the touch panel can be improved when the TSP layer is disposed on the transparent layer.

The display device 100 or the electronic device 101 according to the above-described embodiment may provide a narrow viewing angle depending on a surrounding environment or an input, by disposing the second pixel 121 having a narrower viewing angle than a viewing angle of the first pixel 111. The panel of the display device 100 may include the color filter layer 430 instead of a polarizing plate and thus include the transparent layer 440 to compensate for the reduced thickness of the encapsulation layer 420 to prevent external reflection of light. The panel of the display device 100 including the transparent layer 440 may obtain the distance for implementing a narrow viewing angle, owing to securing the distance between the black matrix 461 and the pixel layer 410. The second pixel 121 of the panel of the display device 100 may provide the narrow viewing angle, by forming the distance **h1** between the black matrix 461 and the pixel layer 410 longer than the width of the second pixel 121.

According to an embodiment, when the touch sensitive layer 450 is disposed on the encapsulation layer 420, the capacitance between the touch sensitive layer 450 and the pixel layer 410 may increase due to the thinned encapsulation layer 420. To reduce the capacitance of the touch sensitive layer 450, the touch sensitive layer 450 may be disposed on the transparent layer 440. The touch sensitive layer 450 may be disposed on the transparent layer 440 for compensating for the viewing angle, so that it may be configured to compensate for the thinned thickness of the encapsulation layer 420 to achieve a faster response rate of the touch sensitive layer 450.

According to an embodiment, in order to reduce degradation of the image quality due to reflection of light and a change in refractive index by the touch sensitive layer 450 disposed on the transparent layer 440, the touch sensitive electrode 453 and the bridge 454 of the touch sensitive layer 450 may be disposed under the black matrix, and the insulation layer 451 and the protective layer 452 of the touch sensitive layer 450 may include openings in portions corresponding to the pixels. These openings may correspond to openings surrounded by the black matrix 461.

The touch sensitive electrode 453 may be disposed between the black matrix portion 461 of the masking layer 460 and the insulation layer 451, and may include a protective layer 452 surrounding the touch sensitive electrodes 453 with the insulation layer 451. A portion of the insulation layer 451 and a portion of the protective layer 452 may include light transmittance portions 468 and 469 through which light from the second pixel passes.

The insulation layer 451 may have a refractive index different from that of the transparent layer 440. The light transmittance portion of the touch sensitive layer 450 and the light transmittance portion of the black matrix portion may be filled with a material having the same refractive index.

According to an embodiment, a width of the black matrix portion 461 may be greater than a width of the touch sensitive electrode 453.

According to an embodiment, the display device may further include an encapsulation layer 420 disposed on the pixel layer 410 to encapsulate the pixel layer 410. The display device may further include a color filter layer 430 disposed on the encapsulation layer and including color filters corresponding to the first pixel 111 and the second pixel 121.

According to an embodiment, a thickness of the encapsulation layer 420 may be less than a thickness of the transparent layer 440.

The display device may further include a polarized layer disposed on the masking layer.

According to an embodiment, the black matrix portion 461 of the masking layer 460 may correspond to a portion of the pixel layer 410 including the second pixel 121, and a portion of the masking layer 460 corresponding to the remaining portion of the pixel layer 410 including the first pixel 111 may be opened.

The black matrix portion 461 may be disposed along edges of the first light transmittance portion 468 and the second light transmittance portion 469, and/or along a periphery of the transparent portion(s) of the masking layer 460.

The touch sensitive electrode 453 of the touch sensitive layer 450 may overlap the black matrix portion 461 disposed on the portion of the pixel layer 410 including the second pixel 121 of the first pixel 111 and the second pixel 121.

A portion of the black matrix of the masking layer 460 disposed on the second pixel may divide sub-pixels included in the second pixel 121.

The electronic device may further include a planarization layer 462 disposed on the masking layer 460, and a portion of the planarization layer 462 may fill the first light transmittance portion 468 and the second light transmittance portion 469 of the masking layer.

The pixel layer 410 may include a pixel definition member for dividing into a plurality of cells, and sub-pixels of the first pixel and the second pixel may be disposed in each of the plurality of cells.

The black matrix portion 461 of the masking layer 460 may overlap the second partition wall, when the display device 100 is viewed from above.

The display device may further include display driving circuitry operatively coupled to the first pixel 111 and the second pixel 121.

The display driving circuitry may be configured to provide a first mode for displaying an image based on driving both the first pixel 111 and the second pixel 121, and provide a second mode for displaying an image based on driving the entire second pixel 121 and a portion of the first pixel 111, or driving the second pixel 121 of the first pixel 111 and the second pixel 121.

The electronic device may further include a first optical member (e.g., the first optical member 1010 of FIG. 9A) disposed in the first pixel 111, and a viewing angle of light emitted from the first pixel 111 and passing through the first optical member 1010 may be greater than the first viewing angle.

The electronic device may further include second optical members (e.g., the second optical members 1020 of FIG. 9A) disposed in the second pixel 121, and a viewing angle of light emitted from the second pixel 121 and passing through the second optical member 1020 may be less than the second viewing angle.

According to an embodiment, the display device may include a pixel layer 410 including a first pixel 111 and a second pixel 121 positioned adjacent to the first pixel 111. The display device may further include a transparent layer 440 disposed above the pixel layer 410. The display device may further include a touch sensitive layer disposed on the transparent layer 440 and including an insulation layer 451 and a plurality of touch sensitive electrodes 453. The display device may include a masking layer 460 disposed on the touch sensitive layer 450. The masking layer 460 may include a black matrix portion (e.g., the black matrix 461 of FIG. 4A), and light transmittance portions 468 and 469 disposed such that light from the first pixel 111 is emitted at a first viewing angle limited by a portion of the black matrix portions 461 and light from the second pixel 121 is emitted at a second viewing angle limited by a portion of the black matrix portions 461. The second viewing angle may be less than the first viewing angle. The touch sensitive layer 450 may be visually covered by the black matrix portion 461.

The touch sensitive layer 450 may include an insulation layer 451 disposed on the transparent layer 440, a touch sensitive electrode 453 disposed between the black matrix portion 461 of the masking layer 460 and the insulation layer 451, and a protective layer 452 surrounding the touch sensitive electrode 453 together with the insulation layer 451.

A portion of the insulation layer 451 and a portion of the protective layer 452 may be opened at a portion corresponding to the light transmittance portion 468 of the masking layer 460.

The insulation layer 451 may have a refractive index different from that of the transparent layer 440, and an optical path from the first pixel 111 and the second pixel 121 to an outside of the display device 100 may pass through the portion corresponding to the light transmittance portion of the masking layer of the touch sensitive layer 450.

The display device may further include a planarization layer 462 disposed on the masking layer 460. A portion of the planarization layer 462 may fill the first light transmittance portion 468 and the second light transmittance portion 469.

The display device may include display driving circuitry operatively coupled to the first pixel 111 and the second pixel 121, wherein the display driving circuitry may be configured to provide a first mode for displaying an image based on driving both the first pixel 111 and the second pixel 121, and provide a second mode for displaying an image based on driving the entire second pixel 121 and a portion of the first pixel 111, or driving the second pixel 121 of the first pixel 111 and the second pixel 121.

The effects that can be obtained from the disclosure are not limited to those mentioned above, and other effects not mentioned herein may be clearly understood by those skilled in the art to which the disclosure pertains.

FIG. 13 is a block diagram of an electronic device 1301 in a network environment 1300 according to various embodiments. Referring to FIG. 13, the electronic device 1301 in the network environment 1300 may communicate with an electronic device 1302 via a first network 1398 (e.g., a short-range wireless communication network), or at least one of an electronic device 1304 or a server 1308 via a second network 1399 (e.g., a long-range wireless communication network). According to an embodiment, the electronic device 1301 may communicate with the electronic device 1304 via the server 1308. According to an embodiment, the electronic device 1301 may include a processor 1320, memory 1330, an input module 1350, a sound output module 1355, a display module 1360, an audio module 1370, a sensor module 1376, an interface 1377, a connecting terminal 1378, a haptic module 1379, a camera module 1380, a power management module 688, a battery 1389, a communication module 1390, a subscriber identification module (SIM) 1396, or an antenna module 1397. In some embodiments, at least one of the components (e.g., the connecting terminal 1378) may be omitted from the electronic device 1301, or one or more other components may be added in the electronic device 1301. In some embodiments, some of the components (e.g., the sensor module 1376, the camera module 1380, or the antenna module 1397) may be implemented as a single component (e.g., the display module 1360).

The processor 1320 may execute, for example, software (e.g., a program 1340) to control at least one other component (e.g., a hardware or software component) of the electronic device 1301 coupled with the processor 1320, and may perform various data processing or computation. According to one embodiment, as at least part of the data processing or computation, the processor 1320 may store a command or data received from another component (e.g., the sensor module 1376 or the communication module 1390) in volatile memory 1332, process the command or the data stored in the volatile memory 1332, and store resulting data in non-volatile memory 1334. According to an embodiment, the processor 1320 may include a main processor 1321 (e.g., a central processing unit (CPU) or an application processor (AP)), or an auxiliary processor 1323 (e.g., a graphics processing unit (GPU), a neural processing unit (NPU), an image signal processor (ISP), a sensor hub processor, or a communication processor (CP)) that is operable independently from, or in conjunction with, the main processor 1321. For example, when the electronic device 1301 includes the main processor 1321 and the auxiliary processor 1323, the auxiliary processor 1323 may be adapted to consume less power than the main processor 1321, or to be specific to a specified function. The auxiliary processor 1323 may be implemented as separate from, or as part of the main processor 1321.

The auxiliary processor 1323 may control at least some of functions or states related to at least one component (e.g., the display module 1360, the sensor module 1376, or the communication module 1390) among the components of the electronic device 1301, instead of the main processor 1321 while the main processor 1321 is in an inactive (e.g., sleep) state, or together with the main processor 1321 while the main processor 1321 is in an active state (e.g., executing an application). According to an embodiment, the auxiliary processor 1323 (e.g., an image signal processor or a communication processor) may be implemented as part of another component (e.g., the camera module 1380 or the communication module 1390) functionally related to the auxiliary processor 1323. According to an embodiment, the auxiliary processor 1323 (e.g., the neural processing unit) may include a hardware structure specified for artificial intelligence model processing. An artificial intelligence model may be generated by machine learning. Such learning may be performed, e.g., by the electronic device 1301 where the artificial intelligence is performed or via a separate server (e.g., the server 1308). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 1330 may store various data used by at least one component (e.g., the processor 1320 or the sensor module 1376) of the electronic device 1301. The various data may include, for example, software (e.g., the program 1340) and input data or output data for a command related thereto. The memory 1330 may include the volatile memory 1332 or the non-volatile memory 1334.

The program 1340 may be stored in the memory 1330 as software, and may include, for example, an operating system (OS) 1342, middleware 1344, or an application 1346.

The input module 1350 may receive a command or data to be used by another component (e.g., the processor 1320) of the electronic device 1301, from the outside (e.g., a user) of the electronic device 1301. The input module 1350 may include, for example, a microphone, a mouse, a keyboard, a key (e.g., a button), or a digital pen (e.g., a stylus pen).

The sound output module 1355 may output sound signals to the outside of the electronic device 1301. The sound output module 1355 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 1360 may visually provide information to the outside (e.g., a user) of the electronic device 1301. The display module 1360 may include, for example, a display, a hologram device, or a projector and control circuitry to control a corresponding one of the display, hologram device, and projector. According to an embodiment, the display module 1360 may include a touch sensor adapted to detect a touch, or a pressure sensor adapted to measure the intensity of force incurred by the touch.

The audio module 1370 may convert a sound into an electrical signal and vice versa. According to an embodiment, the audio module 1370 may obtain the sound via the input module 1350, or output the sound via the sound output module 1355 or a headphone of an external electronic device (e.g., an electronic device 1302) (e.g., a speaker or headphone) directly (e.g., wiredly) or wirelessly coupled with the electronic device 1301.

The sensor module 1376 may detect an operational state (e.g., power or temperature) of the electronic device 1301 or an environmental state (e.g., a state of a user) external to the electronic device 1301, and then generate an electrical signal or data value corresponding to the detected state. According to an embodiment, the sensor module 1376 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 1377 may support one or more specified protocols to be used for the electronic device 1301 to be coupled with the external electronic device (e.g., the electronic device 1302) directly (e.g., wiredly) or wirelessly. According to an embodiment, the interface 1377 may include, for example, a high definition multimedia interface (HDMI), a universal serial bus (USB) interface, a secure digital (SD) card interface, or an audio interface.

A connecting terminal 1378 may include a connector via which the electronic device 1301 may be physically connected with the external electronic device (e.g., the electronic device 1302). According to an embodiment, the connecting terminal 1378 may include, for example, a HDMI connector, a USB connector, a SD card connector, or an audio connector (e.g., a headphone connector).

The haptic module 1379 may convert an electrical signal into a mechanical stimulus (e.g., a vibration or a movement) or electrical stimulus which may be recognized by a user via his tactile sensation or kinesthetic sensation. According to an embodiment, the haptic module 1379 may include, for example, a motor, a piezoelectric element, or an electric stimulator.

The camera module 1380 may capture a still image or moving images. According to an embodiment, the camera module 1380 may include one or more lenses, image sensors, image signal processors, or flashes.

The power management module 1388 may manage power supplied to the electronic device 1301. According to one embodiment, the power management module 1388 may be implemented as at least part of, for example, a power management integrated circuit (PMIC).

The battery 1389 may supply power to at least one component of the electronic device 1301. According to an embodiment, the battery 1389 may include, for example, a primary cell which is not rechargeable, a secondary cell which is rechargeable, or a fuel cell.

The communication module 1390 may support establishing a direct (e.g., wired) communication channel or a wireless communication channel between the electronic device 1301 and the external electronic device (e.g., the electronic device 1302, the electronic device 1304, or the server 1308) and performing communication via the established communication channel. The communication module 1390 may include one or more communication processors that are operable independently from the processor 1320 (e.g., the application processor (AP)) and supports a direct (e.g., wired) communication or a wireless communication. According to an embodiment, the communication module 1390 may include a wireless communication module 1392 (e.g., a cellular communication module, a short-range wireless communication module, or a global navigation satellite system (GNSS) communication module) or a wired communication module 1394 (e.g., a local area network (LAN) communication module or a power line communication (PLC) module). A corresponding one of these communication modules may communicate with the external electronic device via the first network 1398 (e.g., a short-range communication network, such as Bluetooth^{™}, wireless-fidelity (Wi-Fi) direct, or infrared data association (IrDA)) or the second network 1399 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 1392 may identify and authenticate the electronic device 1301 in a communication network, such as the first network 1398 or the second network 1399, using subscriber information (e.g., international mobile subscriber identity (IMSI)) stored in the subscriber identification module 1396.

The wireless communication module 1392 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 1392 may support a high-frequency band (e.g., the mmWave band) to achieve, e.g., a high data transmission rate. The wireless communication module 1392 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 1392 may support various requirements specified in the electronic device 1301, an external electronic device (e.g., the electronic device 1304), or a network system (e.g., the second network 1399). According to an embodiment, the wireless communication module 1392 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 1397 may transmit or receive a signal or power to or from the outside (e.g., the external electronic device) of the electronic device 1301. According to an embodiment, the antenna module 1397 may include an antenna including a radiating element composed of a conductive material or a conductive pattern formed in or on a substrate (e.g., a printed circuit board (PCB)). According to an embodiment, the antenna module 1397 may include a plurality of antennas (e.g., array antennas). In such a case, at least one antenna appropriate for a communication scheme used in the communication network, such as the first network 1398 or the second network 1399, may be selected, for example, by the communication module 1390 (e.g., the wireless communication module 1392) from the plurality of antennas. The signal or the power may then be transmitted or received between the communication module 1390 and the external electronic device via the selected at least one antenna. According to an embodiment, another component (e.g., a radio frequency integrated circuit (RFIC)) other than the radiating element may be additionally formed as part of the antenna module 1397.

According to various embodiments, the antenna module 1397 may form a mmWave antenna module. According to an embodiment, the mmWave antenna module may include a printed circuit board, a RFIC disposed on a first surface (e.g., a bottom surface) of the printed circuit board, or adjacent to the first surface and capable of supporting a designated high-frequency band (e.g., the mmWave band), and a plurality of antennas (e.g., array antennas) disposed on a second surface (e.g., a top surface or a side portion) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 1301 and the external electronic device 1304 via the server 1308 coupled with the second network 1399. Each of the electronic devices 1302 or 1304 may be a device of a same type as, or a different type, from the electronic device 1301. According to an embodiment, all or some of operations to be executed at the electronic device 1301 may be executed at one or more of the external electronic devices 1302, 1304, or 1308. For example, if the electronic device 1301 should perform a function or a service automatically, or in response to a request from a user or another device, the electronic device 1301, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 1301. The electronic device 1301 may provide the outcome, with or without further processing of the outcome, as at least part of a reply to the request. To that end, a cloud computing, distributed computing, mobile edge computing (MEC), or client-server computing technology may be used, for example. The electronic device 1301 may provide ultra-low-latency services using, e.g., distributed computing or mobile edge computing. In another embodiment, the external electronic device 1304 may include an internet-of-things (IoT) device. The server 1308 may be an intelligent server using machine learning and/or a neural network. According to an embodiment, the external electronic device 1304 or the server 1308 may be included in the second network 1399. The electronic device 1301 may be applied to intelligent services (e.g., smart home, smart city, smart car, or healthcare) based on 5G communication technology or IoT-related technology.

FIG. 14 is a block diagram 1400 of a display module 1360 according to various embodiments. Referring to FIG. 14, the display module 1360 may include a display 1410 and a display driving integrated circuit (DDI) 1430 for controlling the same. The DDI 1430 may include an interface module 1431, a memory 1433 (e.g., buffer memory), an image processing module 1435, or a mapping module 1437. The DDI 1430 may receive image information including image data or an image control signal corresponding to a command to control the image data, from another component of the electronic device 1301 via the interface module 1431. For example, according to an embodiment, the image information may be received from the processor 1320 (e.g., the main processor 1321 or the application processor) or the auxiliary processor 1323 (e.g., a graphics processing unit) operating independently from the function of the main processor 1321. The DDI 1430 may communicate with the touch circuit 1450, the sensor module 1376 or the like, via the interface module 1431. Further, the DDI 1430 may store at least some of the received image information in the memory 1433, for example, in units of frames. The image processing module 1435 may perform, for example, a pre-processing or a post-processing (e.g., adjustment of resolution, brightness, or size) of at least part of the image data, based at least on characteristics of the image data or characteristics of the display 1410. The mapping module 1437 may generate a voltage value or a current value corresponding to the image data pre-processed or post-processed by the image processing module 1435. According to an embodiment, the generation of the voltage value or the current value may be performed, for example, based at least in part on an attribute (e.g., an array of pixels (an RGB stripe or pentile structure) or a size of each of the subpixels) of the pixels of the display 1410. At least some pixels of the display 1410 may be driven, for example, based at least in part on the voltage value or the current value, so that visual information (e.g., text, an image, or an icon) corresponding to the image data can be displayed through the display 1410.

According to an embodiment, the display module 1360 may further include a touch circuit 1450. The touch circuit 1450 may include a touch sensor 1451 and a touch sensor IC 1453 for controlling the touch sensor 1451. The touch sensor IC 1453 may control, for example, the touch sensor 1451 to detect a touch input or a hovering input for a specific position of the display 1410. For example, the touch sensor IC 1453 may detect a touch input or a hovering input by measuring a change in a signal (e.g., a voltage, an amount of light, a resistance, or an amount of charge) for a specific position of the display 1410. The touch sensor IC 1453 may provide the processor 1320 with information (e.g., a location, an area, a pressure, or a time) about the detected touch input or hovering input. According to an embodiment, at least a part (e.g., the touch sensor IC 1453) of the touch circuit 1450 may be included as a part of the display driver IC 1430 or the display 1410, or as a part of another component (e.g., the auxiliary processor 1323) disposed outside the display module 1360.

According to an embodiment, the display module 1360 may further include at least one sensor (e.g., a fingerprint sensor, an iris sensor, a pressure sensor, or an illuminance sensor) of the sensor module 1376, or a control circuit for the sensor. In such a case, the at least one sensor or the control circuit for the sensor may be embedded in a part (e.g., the display 1410 or the DDI 1430) of the display module 1360 or a part of the touch circuit 1450. For example, when the sensor module 1376 embedded in the display module 1360 includes a biometric sensor (e.g., a fingerprint sensor), the biometric sensor may obtain biometric information (e.g., a fingerprint image) associated with a touch input through a partial area of the display 1410. As another example, when the sensor module 1376 embedded in the display module 1360 includes a pressure sensor, the pressure sensor may obtain pressure information associated with a touch input through a partial area or an entire area of the display 1410. According to an embodiment, the touch sensor 1451 or the sensor module 1376 may be disposed between pixels of the pixel layer of the display 1410, or above or below the pixel layer.

The electronic device according to various embodiments disclosed herein may be one of various types of electronic devices. The electronic devices may include, for example, a portable communication device (e.g., a smartphone), a computer device, a portable multimedia device, a portable medical device, a camera, a wearable device, or a home appliance. The electronic devices according to an embodiment of the disclosure are not limited to those described above.

It should be appreciated that various embodiments and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C" may include any one of, or all possible combinations of the items enumerated together in a corresponding one of the phrases. As used herein, such terms as "1st" and "2nd", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled" or "connected" to/with "another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may be interchangeably used with other terms, for example, "logic", "logic block", "unit", "part", "portion", or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 1340) including one or more instructions that are stored in a storage medium (e.g., an internal memory 1336 or an external memory 1338) that is readable by a machine (e.g., the electronic device 1301). For example, a processor (e.g., the processor 1320) of the machine (e.g., the electronic device 1301) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments disclosed herein may be included and provided in a computer program product. The computer program product may be traded as a product between a seller and a buyer. The computer program product may be distributed in the form of a machine-readable storage medium (e.g., a compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. A display device (100) comprising:
a pixel layer (410) comprising a plurality of pixels including a first pixel (111) and a second pixel (121) positioned adjacent to the first pixel (111),
a masking layer (460) including black matrix, BM, portions (461) and light transmittance portions (468, 469) disposed such that light from the first pixel (111) is emitted with a first viewing angle limited by a portion of the BM portions (461) and light from the second pixel (121) is emitted with a second viewing angle limited by a portion of the BM portions (461), the second viewing angle being narrower than the first viewing angle,
a transparent layer (440) disposed between the pixel layer (410) and the masking layer (460) such that the masking layer (460) is spaced apart by a specified distance from the pixel layer (410) for the second viewing angle, and
a touch sensitive panel, TSP, layer (450), disposed between the masking layer (460) and the transparent layer (440), including an insulation layer (451) and a plurality of touch sensitive electrodes (453),
wherein the insulation layer (451) of the TSP layer (450) is omitted beneath the light transmittance portions (468, 469) of the masking layer (460).

2. The display device (100) of claim 1,
wherein the touch sensitive electrodes (453) are disposed between the BM portions (461) of the masking layer (460) and the insulation layer (451),
wherein the touch sensitive layer includes a protective layer (452) surrounding the touch sensitive electrodes (453) with the insulation layer (451), and
wherein a portion of the insulation layer (451) and a portion of the protective layer (452) include light transmittance portions of the TSP layer (450) through which light from the second pixel (121) is passed.

3. The display device (100) claim 1 or 2, wherein the insulation layer (451) has a refractive index different from a refractive index of the transparent layer (440), and
wherein a material having a same refractive index is filled in the light transmittance portions of the TSP layer (450) and the light transmittance portions of the BM portions (461).

4. The display device (100) of any of claims 1 to 3, wherein a width of the BM portions (461) is larger than a width of the touch sensitive electrodes (453).

5. The display device (100) of any of claims 1 to 4, further comprising:
an encapsulation layer (420) disposed on the pixel layer (410) to encapsulate the pixel layer (410); and
a color filter layer (430) including color filters corresponding to the first pixel (111) and the second pixel (121) and disposed on the encapsulation layer (420).

6. The display device (100) of any of claims 1 to 5, further comprising a polarized layer disposed on the masking layer (460).

7. The display device (100) of any of claims 1 to 6, wherein the BM portions (461) of the masking layer (460) correspond to a portion of the pixel layer (410) in which the second pixel (121) is located,
wherein a portion of the masking layer (460) corresponding to a remaining portion of the pixel layer (410) in which the first pixel (111) is located is opened, and
wherein the BM portions (461) of the masking layer (460) are disposed along a periphery of the light transmittance portions (468, 469) of the masking layer (460).

8. The display device (100) of any of claims 1 to 7, wherein the touch sensitive electrodes (453) overlap the BM portions (461) disposed on a portion of the pixel layer (410) including the second pixel (121).

9. The display device (100) of any of claims 1 to 8, wherein a portion of the BM portions of the masking layer (460) disposed on the second pixel (121) divides sub-pixels included in the second pixel (121).

10. The display device (100) of any of claims 1 to 9, further comprising a planarization layer (462) disposed on the masking layer (460);
wherein a portion of the planarization layer (462) fills the light transmittance portion of the masking layer (460).

11. The display device (100) of any of claims 1 to 10, wherein the pixel layer (410) includes a pixel definition member (405) dividing into a plurality of cells, and
wherein sub-pixels of the first pixel (111) and the second pixel (121) are disposed in each of the plurality of cells.

12. The display device (100) of any of claims 1 to 11, wherein the BM portions (461) of the masking layer (460) overlap the second partition, when viewing the display device from above.

13. The display device (100) of any of claims 1 to 12, further comprising display driving circuitry operably coupled to the first pixel (111) and the second pixel (121),
wherein the display driving circuitry is configured to:
provide a first mode for displaying an image based on driving both the first pixel (111) and the second pixel (121); and
provide a second mode for displaying an image based on driving all of the second pixel (121) and some of the first pixel (111) or driving only the second pixel (121).

14. The display device (100) of any of claims 1 to 13, further comprising a first optical member (1010) disposed on the first pixel (111),
wherein a viewing angle of the first pixel (111) under the first optical member (1010) is wider than the first viewing angel.

15. The display device (100) of any of claims 1 to 14, further comprising a second optical member (1020) disposed on the second pixel (121),
wherein a viewing angle of light emitted from the second pixel (121) and passed through the second optical member (1020) is less than the second viewing angel.
